# EUROPEAN PATENT SPECIFICATION

(11) **EP 4 016 515 B1**
(45) Date of publication and mention of the grant of the patent: **01.10.2025**
(21) Application number: 21214257.4
(22) Date of filing: 14.12.2021
(51) Int. Cl.: G09G 3/3233, G09G 3/3266

(54) **ORGANIC LIGHT EMITTING DISPLAY DEVICE**
ORGANISCHE LICHTEMITTIERENDE ANZEIGEVORRICHTUNG
ÉCRAN À DIODES ÉLECTROLUMINESCENTES ORGANIQUES

(30) Priority: 18.12.2020 KR 20200178859
(43) Date of publication of application: 22.06.2022
(60) Divisional application: 25198445.6
(73) Proprietor: LG Display Co., Ltd., SEOUL, 07336 (KR)
(72) Inventor: Kim, Minsu, 10845 Gyeonggi-do (KR); Park, WonKeun, 10845 Gyeonggi-do (KR); Park, Haejun, 10845 Gyeonggi-do (KR); Kang, Jieun, 10845 Gyeonggi-do (KR); Hong, Youngtaek, 10845 Gyeonggi-do (KR)
(74) Representative: Ter Meer Steinmeister & Partner

(56) References cited:
- CN-A- 106 097 976
- US-A1- 2019 385 530
- US-A1- 2020 226 978

## Description

This application claims the priority of Korean Patent Application No. 10-2020-0178859 filed on December 18, 2020, in the Korean Intellectual Property Office.

### BACKGROUND

### Field

The present disclosure relates to an organic light emitting display device, and more particularly, to an organic light emitting display device having a variable driving frequency.

### Description of the Related Art

An organic light emitting diode (OLED) which is a self-emitting device includes an anode electrode, a cathode electrode, and an organic compound layer formed therebetween. The organic compound layer comprises at least a hole transport layer (HTL), an emission layer (EML), and an electron transport layer (ETL). When a driving voltage is applied to the anode electrode and the cathode electrode, holes which pass through the hole transport layer HTL and electrons which pass through the electron transport layer ETL move to the emission layer EML to form excitons so that the emission layer EML generates visible rays. An active matrix type organic light emitting display device includes one or more an organic light emitting diodes OLED which is a self-emitting device and is used in various ways with the advantages of a fast response speed, large emission efficiency, luminance, and viewing angle.

The organic light emitting display device comprises pixels, each including an organic light emitting diode, the pixels are disposed in a matrix, wherein the luminance of the pixel is adjusted in accordance with a gray scale level of video data.

Each pixel includes at least an organic light emitting diode, a driving transistor configured to control a driving current flowing through the organic light emitting diode in accordance with a voltage between the gate and the source and at least one switching transistor which programs the voltage between the gate and the source of the driving transistor.

As the driving of the organic light emitting display device is maintained, a hysteresis phenomenon in which a threshold voltage Vth of the driving transistor changes occurs. In order to relieve the hysteresis phenomenon of the driving transistor, an on bias stress needs to be applied to the driving transistor to flow the source-drain current Ids of the driving transistor. In order to apply the on bias stress to the driving transistor, it is necessary to raise an initialization voltage which might be a low level to a high level even in one frame.

Therefore, a separate stage for the swing of the initialization voltage needs to be provided, which is preferably included in the gate driver. Accordingly, the organic light emitting display device includes a separate stage in the gate driver to apply an on bias stress to the driving transistor so that there are problems in that a bezel is increased and a driving power consumption is increased
US 2020/226978 A1 relates to a display pixel that is operable to support a hybrid compensation scheme having both in-pixel threshold voltage canceling and external threshold voltage compensation. An on-bias stress phase may be performed prior to a threshold voltage sampling and data programming phase to mitigate hysteresis and improve first frame response.
CN 106 097 976 A relates to a pixel driving circuit which comprises a first resetting unit, a threshold compensation unit, a data signal input unit, a driving unit and a luminescent unit, wherein the first resetting unit, the threshold compensation unit and the data signal input unit respectively provide resetting signals, threshold compensation and data signal voltage to the driving unit under control of a first control signal, a second control signal and a third control signal.
US 2019/385530 A1 relates to a pixel circuit, comprising a driving resetting sub-circuit, a writing compensation sub-circuit, a light-emitting resetting sub-circuit, a light-emitting enabling sub-circuit, a driving sub-circuit, and a light-emitting device. The driving sub-circuit comprises a driving transistor having a source connected to the writing compensation sub-circuit.

### SUMMARY

An organic light emitting display device with a newly designed pixel circuit to apply an on bias stress without including a separate stage is disclosed.

Accordingly, an object of the present disclosure is to provide an organic light emitting display device configured to apply an on bias stress to the driving transistor without increasing the bezel.

Another object to be achieved by the present disclosure is to provide a display device and a method for operating a display device which relieves the hysteresis of the driving transistor while reducing power consumption.

The object is solved by the features of claim 1. Preferred embodiments are given in the dependent claims.

### BRIEF DESCRIPTION OF THE DRAWINGS

The above and other aspects, features and other advantages of the present disclosure will be more clearly understood from the following detailed description taken in conjunction with the accompanying drawings, in which:
FIG. 1 is a block diagram of an organic light emitting display device according to an exemplary embodiment of the present disclosure;
FIG. 2 is a circuit diagram illustrating a pixel of an organic light emitting display device according to an exemplary embodiment of the present disclosure;
FIG. 3 is a waveform illustrating a signal which is applied to a pixel of an organic light emitting display device during one frame of an exemplary embodiment of the present disclosure;
FIG. 4A is a circuit diagram of a pixel of an organic light emitting display device during an on bias stress period according to an exemplary embodiment of the present disclosure;
FIG. 4B is a circuit diagram of a pixel of an organic light emitting display device during an initial period according to an exemplary embodiment of the present disclosure;
FIG. 4C is a circuit diagram of a pixel of an organic light emitting display device during a sampling period according to an exemplary embodiment of the present disclosure;
FIG. 4D is a circuit diagram of a pixel of an organic light emitting display device during an emission period according to an exemplary embodiment of the present disclosure;
FIG. 5 is a view illustrating a gate driver of an organic light emitting display device according to an exemplary embodiment of the present disclosure;
FIG. 6 is a circuit diagram illustrating a pixel of an organic light emitting display device according to another exemplary embodiment of the present disclosure;
FIG.7 is a waveform illustrating a signal which is applied to a pixel of an organic light emitting display device during one frame of another exemplary embodiment of the present disclosure;
FIG. 8A is a circuit diagram of a pixel of an organic light emitting display device during an on bias stress period according to another exemplary embodiment of the present disclosure;
FIG. 8B is a circuit diagram of a pixel of an organic light emitting display device during an initial period according to another exemplary embodiment of the present disclosure;
FIG. 8C is a circuit diagram of a pixel of an organic light emitting display device during a sampling period according to another exemplary embodiment of the present disclosure;
FIG. 8D is a circuit diagram of a pixel of an organic light emitting display device during an emission period according to another exemplary embodiment of the present disclosure;
FIG. 9 is a view illustrating a gate driver of an organic light emitting display device according to another exemplary embodiment of the present disclosure.
FIG. 10 is a circuit diagram illustrating a pixel of an organic light emitting display device according to still another exemplary embodiment of the present disclosure;
FIG. 11A circuit diagram of a pixel of an organic light emitting display device during an on bias stress period according to still another exemplary embodiment of the present disclosure;
FIG. 11B circuit diagram of a pixel of an organic light emitting display device during an initial period according to still another exemplary embodiment of the present disclosure;
FIG. 11C is a circuit diagram of a pixel of an organic light emitting display device during an emission period of still another exemplary embodiment (Ex. 3) of the present disclosure;
FIG. 11D is a circuit diagram of a pixel of an organic light emitting display device during an emission period according to still another exemplary embodiment of the present disclosure;
FIG. 12 is a circuit diagram illustrating a pixel of an organic light emitting display device according to still another exemplary embodiment of the present disclosure;
FIG. 13A is a circuit diagram of a pixel of an organic light emitting display device during an on bias stress period according to still another exemplary embodiment of the present disclosure;
FIG. 13B is a circuit diagram of a pixel of an organic light emitting display device during an initial period according to still another exemplary embodiment of the present disclosure;
FIG. 13C is a circuit diagram of a pixel of an organic light emitting display device during a sampling period of still another exemplary embodiment of the present disclosure; and
FIG. 13D is a circuit diagram of a pixel of an organic light emitting display device during an emission period according to still another exemplary embodiment of the present disclosure.

### DETAILED DESCRIPTION

Advantages and characteristics of the present disclosure and a method of achieving the advantages and characteristics will be clear by referring to exemplary embodiments described below in detail together with the accompanying drawings. The exemplary embodiments are provided by way of example only so that those skilled in the art can fully understand the disclosures of the present disclosure and the scope of the present disclosure. Therefore, the present disclosure will be defined only by the scope of the appended claims.

The shapes, sizes, ratios, angles, numbers, and the like illustrated in the accompanying drawings for describing the exemplary embodiments of the present disclosure are merely examples, and the present disclosure is not limited thereto. Like reference numerals generally denote like elements throughout the specification. Further, in the following description of the present disclosure, a detailed explanation of known related technologies may be omitted to avoid unnecessarily obscuring the subject matter of the present disclosure. The terms such as "including," "having," and "comprising" used herein are generally intended to allow other components to be added unless the terms are used with the term "only". Any references to singular may include plural unless expressly stated otherwise.

Components are interpreted to include an ordinary error range even if not expressly stated.

When the position relation between two parts is described using the terms such as "on", "above", "below", and "next", one or more parts may be positioned between the two parts unless the terms are used with the term "immediately" or "directly".

When an element or layer is disposed "on" another element or layer, another layer or another element may be interposed directly on the other element or therebetween.

Although the terms "first", "second", and the like are used for describing various components, these components are not confined by these terms. These terms are merely used for distinguishing one component from the other components. Therefore, a first component to be mentioned below may be a second component in a technical concept of the present disclosure.

Same reference numerals generally denote same elements throughout the specification.

A size and a thickness of each component illustrated in the drawing are illustrated for convenience of description, and the present disclosure is not limited to the size and the thickness of the component illustrated.

A low level of a signal may be defined as a first level and a high level of a signal may be defined as a second level

Hereinafter, a display device according to exemplary embodiments of the present disclosure will be described in detail with reference to accompanying drawings.

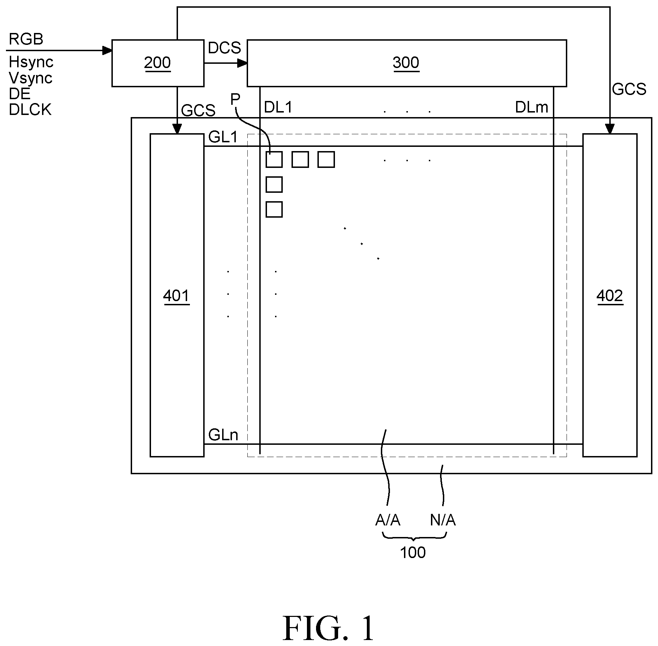

FIG. 1 is a block diagram of an organic light emitting display device according to an exemplary embodiment of the present disclosure.

Referring to FIG. 1, an organic light emitting display device according to an exemplary embodiment of the present disclosure includes a display panel 100, a timing control circuit 200, a data driver 300, and gate drivers 401 and 402.

The display panel 100 includes a display area A/A which displays images and a non-display area N/A which is disposed at the outside of the display area A/A and has various signal lines and the gate drivers 401 and 402 disposed therein. The non-display area N/A does not disclose images.

In the display area A/A, in order to display images, a plurality of pixels P is disposed. In the display area A/A, n gate lines GL1 to GLn are disposed in a first direction and m data lines DL1 to DLm are disposed in a direction different from the first direction. The plurality of pixels P are electrically connected to the n gate lines GL1 to GLn and the m data lines DL1 to DLm. Accordingly, gate voltages and data voltages are applied to the pixels P through the gate lines GL1 to GLn and the data lines DL1 to DLm, respectively. Further, each pixel P implements gray scales by the gate voltage and the data voltage. Accordingly, the image is displayed in the display area A/A by the gray scale displayed by each pixel P.

In the non-display area N/A, various signal lines GL1 to GLn and DL1 to DLm which transmit signals to control the operation of the pixels P disposed in the display area A/A and the gate drivers 401 and 402 are disposed.

The timing control circuit 200 transmits an input image data RGB, which is received from a host system, to the data driver 300.

The timing control circuit 200 generates control signals GCS and DCS for controlling operation timings of the gate drivers 401 and 402 and the data driver 300 using timing signals, such as a clock signal DCLK, a horizontal synchronization signal Hsync, a vertical synchronization signal Vsync, and a data enable signal DE. The timing signals are received together with the image data RGB. In this case, the horizontal synchronization signal Hsync is a signal indicating a time taken to display one horizontal line of a screen and the vertical synchronization signal Vsync is a signal indicating a time taken to display a screen of one frame. Further, the data enable signal DE is a signal indicating a period when a data voltage is supplied to a pixel P defined in the display panel 100.

In other words, the timing control circuit 200 is applied with the timing signal to output a gate control signal GCS to the gate drivers 401 and 402 and output a data control signal DCS to the data driver 300.

The data driver 300 is applied with the data control signal DCS to output a data voltage to the data lines DL1 to DLm.

Specifically, the data driver 300 generates a sampling signal in accordance with the data control signal DCS and latches the image data RGB in accordance with the sampling signal to be converted into a data voltage and then supplies the data voltage to the data lines DL1 to DLm in response to a source output enable (SOE) signal.

The data driver 300 is connected to a bonding pad of the display panel 100 by a chip on glass (COG) method or may be directly disposed on the display panel 100. In some cases, the data driver 300 may be disposed to be integrated with the display panel 100. Further, the data driver 300 may be disposed by a chip on film (COF) method.

The gate drivers 401 and 402 sequentially supply a scan signal and an emission signal corresponding to the gate voltage to the gate lines GL1 to GLn, in accordance with the gate control signal GCS.

The general gate drivers 401 and 402 are formed independently from the display panel 100 to be electrically connected to the display panel in various ways. However, the gate drivers 401 and 402 of the organic light emitting display device according to the exemplary embodiment of the present disclosure are formed to have a thin film pattern when a substrate of the display panel 100 is manufactured to be embedded on the non-display area N/A in a gate in panel GIP manner.

The gate drivers 401 and 402 may be divided into a first gate driver 401 and a second gate driver 402 which are disposed on both sides of the display panel 100.

Specifically, the first gate driver 401 supplies the scan signal and the emission signal to the plurality of pixels P. Therefore, the first gate driver 401 may include a plurality of scan driving stages and a plurality of emission driving stages. The plurality of scan driving stages supplies the scan signal to the plurality of pixels P and the plurality of emission driving stages supplies the emission signal to the plurality of pixels P.

The second gate driver 402 also supplies the scan signal and the emission signal to the plurality of pixels P. Therefore, the second gate driver 402 may include a plurality of scan driving stages and a plurality of emission driving stages. The plurality of scan driving stages supplies the scan signal to the plurality of pixels P and the plurality of emission driving stages supplies the emission signal to the plurality of pixels P.

Hereinafter, a configuration and a driving method of the plurality of pixels P will be described in detail.

Switch elements which configure each of the plurality of pixels P may be implemented by an n-type and/or a p-type MOSFET transistor. In the following exemplary embodiment, an n-type transistor will be described as an example, but the present disclosure is not limited thereto.

Additionally, a transistor is a three-electrode element including a gate electrode, a source electrode, and a drain electrode. The source electrode is an electrode which supplies carriers to the transistor. In the transistor, the carriers flow from the source electrode. The drain electrode is an electrode through which the carriers leave the transistor to the outside. Accordingly, the carrier in the MOSFET flows from the source electrode to the drain electrode. In the case of the n-type MOSFET NMOS, since the carriers are electrons, in order to allow the electrons to flow from the source electrode to the drain electrode, a voltage of the source electrode is less than a voltage of the drain electrode. In the n-type MOSFET, since the electrons flow from the source electrode to the drain electrode, the current flows from the drain electrode to the source electrode. In the case of the p-type MOSFET (PMOS), since the carriers are holes, in order to allow the holes to flow from the source electrode to the drain electrode, a voltage of the source electrode is higher than a voltage of the drain electrode. In the p-type MOSFET, since the holes flow from the source electrode to the drain electrode, the current flows from the source electrode to the drain electrode. However, it should be noted that the source electrode and the drain electrode of the MOSFET are not fixed. For example, the source electrode and the drain electrode of the MOSFET may be changed depending on the applied voltage. In the following exemplary embodiment, the present disclosure should not be limited by the source electrode and the drain electrode of the transistor.

Further, in the following description, for the convenience of description, a high level voltage and a low level voltage have been mentioned, but the present disclosure is not limited thereto. Therefore, the high level voltage and the low level voltage may be changed to a low level voltage and a high level voltage in accordance with a type of the transistor and the high level voltage may be defined as a first level and the low level voltage may be defined as a second level.

### <One exemplary embodiment of present disclosure - Example 1>

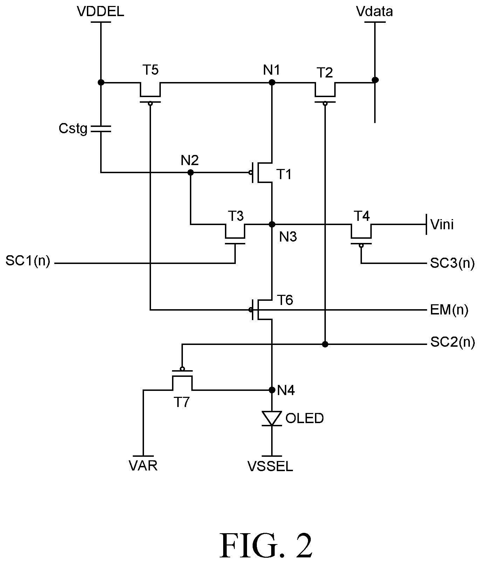

FIG. 2 is a circuit diagram illustrating a pixel of an organic light emitting display device according to an exemplary embodiment of the present disclosure.

Each pixel P includes an organic light emitting diode OLED, a driving transistor T1, second to seventh transistors T2 to T7, and a storage capacitor Cstg.

The organic light emitting diode OLED emits light by a driving current supplied from the driving transistor T1. A multilayered organic compound layer is formed between the anode electrode and the cathode electrode of the organic light emitting diode OLED. The organic compound layer may include at least one of a hole transfer layer and an electron transfer layer and an emission layer (EML). Here, the hole transfer layer is a layer which injects or transfers holes to the emission layer and for example, may include a hole injection layer (HIL), a hole transport layer (HTL), and an electron blocking layer (EBL). The electron transfer layer is a layer which injects or transfers the electrons to the emission layer and for example, may include an electron transport layer (ETL), an electron injection layer (EIL), and a hole blocking layer (HBL). An anode electrode of the organic light emitting diode OLED is connected to a fourth node N4 and a cathode electrode of the organic light emitting diode is connected to an input terminal of a low potential driving voltage VSSEL.

The driving transistor T1 controls a driving current applied to the organic light emitting diode OLED in accordance with a source-gate voltage Vsg. The driving transistor T1 may be a p-type MOSFET (PMOS) and a low temperature polycrystalline silicon (LTPS) thin film transistor. A source electrode of the driving transistor T1 is connected to a first node N1, a gate electrode is connected to a second node N2, and a drain electrode is connected to a third node N3. The driving transistor T1 may be referred to as a first transistor.

The second transistor T2 applies a data voltage Vdata supplied from a data line to the first node N1 which is the source electrode of the driving transistor T1. The second transistor T2 may be a p-type MOSFET (PMOS) and a low temperature polycrystalline silicon (LTPS) thin film transistor. The second transistor T2 includes a source electrode connected to the data line, a drain electrode connected to the first node N1, and a gate electrode connected to a second scan signal line which transmits a second scan signal SC2(n). Accordingly, the second transistor T2 applies a data voltage Vdata supplied from the data line to the first node N1 which is the source electrode of the driving transistor T1, in response to a low level of the second scan signal SC2(n) which is a turn on level.

The third transistor T3 forms a diode connection between a gate electrode and a drain electrode of the driving transistor T1. The third transistor T3 may be an n-type MOSFET (NMOS) and an oxide thin film transistor to reduce a leakage current. The third transistor T3 includes the drain electrode connected to the third node N3, a source electrode connected to the second node N2, and the gate electrode connected to a first scan signal line which transmits a first scan signal SC1(n). Therefore, the third transistor T3 forms a diode connection between the gate electrode and the drain electrode of the driving transistor T1 in response to a high level of the first scan signal SC1(n) which is a turn on level.

The fourth transistor T4 applies an initialization voltage Vini to the third node N3 which is the drain electrode of the driving transistor T1. The fourth transistor T4 may be a p-type MOSFET (PMOS) and a low temperature polycrystalline silicon (LTPS) thin film transistor. The fourth transistor T4 includes a source electrode connected to an initialization voltage line which transmits an initialization voltage Vini, a drain electrode connected to the third node N3, and a gate electrode connected to a third scan signal line which transmits a third scan signal SC3(n). Accordingly, the fourth transistor T4 applies the initialization voltage Vini to the third node N3 which is the drain electrode of the driving transistor T1, in response to a low level of third scan signal SC3(n) which is a turn on level.

The fifth transistor T5 applies a high potential driving voltage VDDEL to the first node N1 which is the source electrode of the driving transistor T1. The fifth transistor T5 may be a p-type MOSFET (PMOS) and a low temperature polycrystalline silicon (LTPS) thin film transistor. The fifth transistor T5 includes a source electrode connected to a high potential driving voltage line which transmits a high potential driving voltage VDDEL, a drain electrode connected to the first node N1, and a gate electrode connected to an emission signal line which transmits an emission signal EM(n). Accordingly, the fifth transistor T5 applies the high potential driving voltage VDDEL to the first node N1 which is the source electrode of the driving transistor T1, in response to a low level of emission signal EM(n) which is a turn on level.

The sixth transistor T6 forms a current path between the driving transistor T1 and the organic light emitting diode OLED. The sixth transistor T6 may be a p-type MOSFET (PMOS) and a low temperature polycrystalline silicon (LTPS) thin film transistor. The sixth transistor T6 includes a source electrode connected to the third node N3, a drain electrode connected to the fourth node N4, and a gate electrode connected to the emission signal line which transmits an emission signal EM(n). The sixth transistor T6 forms a current path between the third node N3 which is the source electrode of the sixth transistor T6 and the fourth node N4 which is the drain electrode of the sixth transistor T6, in response to the emission signal EM(n). Accordingly, the sixth transistor T6 forms a current path between the driving transistor T1 and the organic light emitting diode OLED in response to a low level of emission signal EM(n) which is a turn on level.

The seventh transistor T7 applies a reset voltage VAR to the fourth anode N4 which is an anode of the organic light emitting diode. The seventh transistor T7 may be a p-type MOSFET (PMOS) and a low temperature polycrystalline silicon (LTPS) thin film transistor. The seventh transistor T7 includes a source electrode connected to the reset voltage line which transmits the reset voltage VAR, a drain electrode connected to the fourth node N4, and a gate electrode connected to a second scan signal line which transmits a second scan signal SC2(n). Accordingly, the seventh transistor T7 applies the reset voltage VAR to the fourth node N4 which is the anode of the organic light emitting diode, in response to a low level of second scan signal SC2(n) which is a turn on level.

The storage capacitor Cstg holds a data voltage Vdata stored in each pixel for one frame. The storage capacitor Cstg includes a first electrode connected to the second node N2 and a second electrode connected to the high potential driving voltage line which transmits a high potential driving voltage VDDEL. That is, one electrode of the storage capacitor Cstg is connected to the gate electrode of the driving transistor T1 and the other electrode of the storage capacitor Cstg is connected to the high potential driving voltage line which transmits a high potential driving voltage VDDEL.

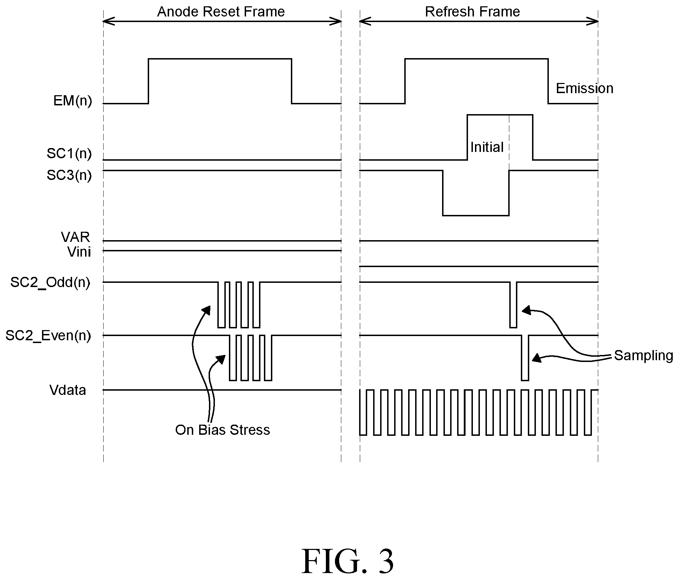

FIG. 3 is a waveform illustrating a signal which is applied to a pixel of an organic light emitting display device according to an exemplary embodiment of the present disclosure during one frame.

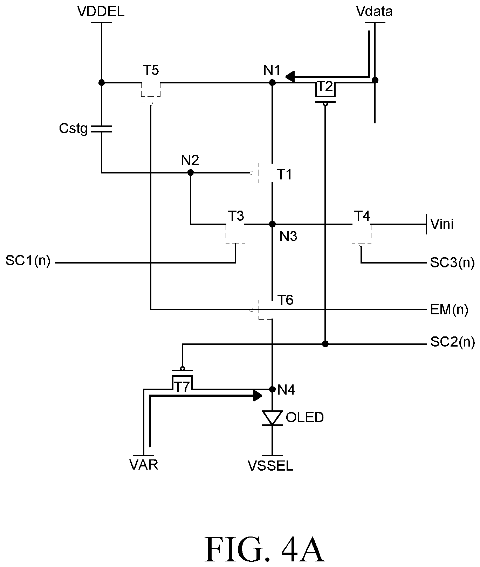

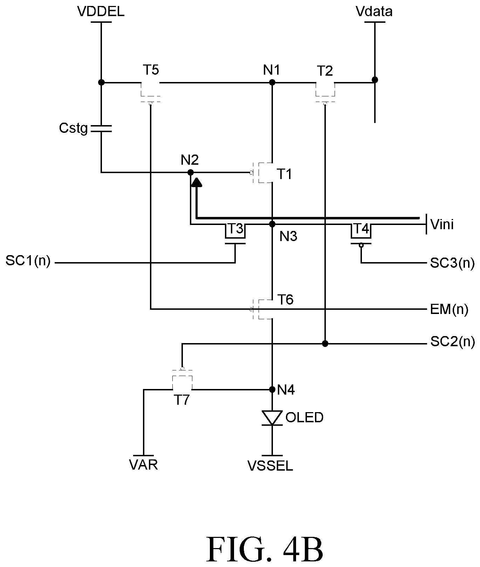

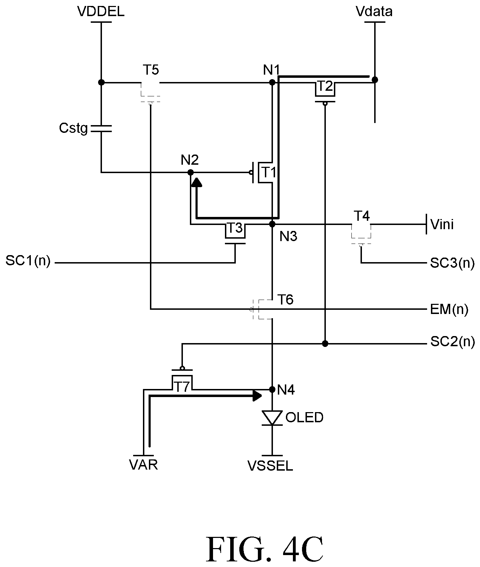

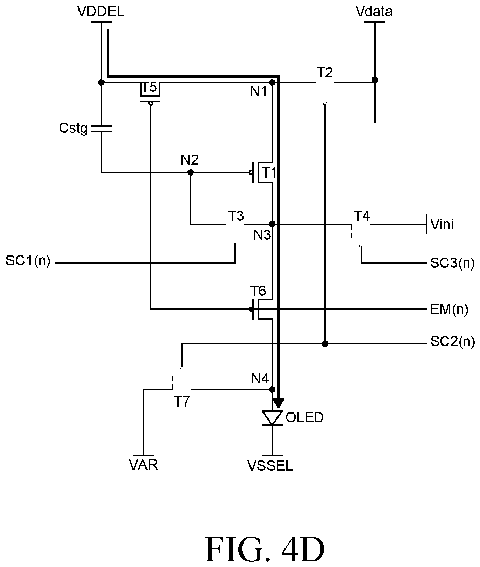

FIG. 4A is a circuit diagram of a pixel of an organic light emitting display device during an on bias stress period according to an exemplary embodiment of the present disclosure. FIG. 4B is a circuit diagram of a pixel of an organic light emitting display device during an initial period according to an exemplary embodiment of the present disclosure. FIG. 4C is a circuit diagram of a pixel of an organic light emitting display device during a sampling period according to an exemplary embodiment of the present disclosure. FIG. 4D is a circuit diagram of a pixel of an organic light emitting display device during an emission period according to an exemplary embodiment of the present disclosure.

The driving of the pixel of the organic light emitting display device according to the exemplary embodiment of the present disclosure will be described with reference to FIGS. 2 to 4D, as follows.

The organic light emitting display device according to the exemplary embodiment of the present disclosure may be driven to be divided into a refresh frame and an anode reset frame. In the refresh frame, the data voltage Vdata is programmed in each pixel P and the organic light emitting diode OLED emits light. The anode reset frame may be a vertical blank frame and the anode electrode of the organic light emitting diode OLED is reset during the anode reset frame.

In the organic light emitting display device according to the exemplary embodiment of the present disclosure, the anode reset frame may include a plurality of on bias stress periods (hereinafter, referred to as "stress periods"). The stress period (on bias stress) is a period in which a bias stress is applied to the first node N1 which is the source electrode of the driving transistor T1. Further, during the stress period, the anode electrode of the organic light emitting diode OLED may be reset. Further, as illustrated in FIG. 3, during the anode reset frame, the reset voltage VAR is a low level and the initialization voltage Vini and the data voltage Vdata are high levels.

In the organic light emitting display device according to the exemplary embodiment of the present disclosure, the refresh frame may be divided into an initial period, a sampling period, and an emission period. The initial period is a period in which the voltage of the third node N3 which is the drain electrode of the driving transistor T1 is initialized. The sampling period is a period in which a threshold voltage Vth of the driving transistor T1 is sampled and the data voltage Vdata is programmed. The emission period is a period in which the organic light emitting diode OLED emits light in accordance with the driving current by the source-gate voltage of the programmed driving transistor T1. As illustrated in FIG. 3, during the refresh frame, the reset voltage VAR and the initialization voltage Vini are low levels.

Specifically, referring to FIGS. 3 and 4A, during the stress period (on bias stress) of the anode reset frame, the second scan signal SC2(n) is a low level which is a turn on level. That is, during the stress period (on bias stress) of the anode reset frame, an odd-numbered second scan signal SC2_Odden) is a low level which is a turn on level and an even-numbered second scan signal SC2_Even(n) is a low level which is a turn on level. In other words, in the anode reset frame including a plurality of stress periods (on bias stress), the odd-numbered second scan signal SC2_Odden) and the even-numbered second scan signal SC2_Even(n) which are second scan signals SC2(n) may have a waveform including a plurality of pulses. In the anode reset frame including a plurality of stress periods (on bias stress), the data voltage Vdata is always a high level.

Therefore, the seventh transistor T7 is turned on to apply the reset voltage VAR to the fourth node N4. That is, the anode electrode of the organic light emitting diode OLED is reset to the reset voltage VAR.

Therefore, the second transistor T2 is turned on to apply a high level of data voltage Vdata to the first node N1. The high level of data voltage Vdata may be selected in a voltage range which is sufficiently higher than an operating voltage of the organic light emitting diode OLED and may be set to a voltage equal to or less than a high potential driving voltage VDDEL. That is, during the stress period (on bias stress), the on bias stress is applied to the first node N1 which is the source electrode of the driving transistor T1 to drop the gate-source voltage Vgs of the driving transistor T1. Accordingly, during the stress period (on bias stress), the source-drain current Ids of the driving transistor T1 flows to relieve the hysteresis of the driving transistor T1.

In the anode reset frame, the initialization voltage Vini may be a high level. Therefore, a high level of third scan signal SC3(n) is applied to the gate electrode of the fourth transistor T4 and a high level of initialization voltage Vini is applied to the source electrode of the fourth transistor T4 so that a potential difference between the gate electrode and the source electrode of the fourth transistor T4 may be reduced. Accordingly, during the anode reset frame, the leakage current of the fourth transistor T4 may be reduced.

Referring to FIGS. 3 and 4B, during an initial period of the refresh frame, the first scan signal SC1(n) is a high level which is a turn on level and the third scan signal SC3(n) is a low level which is a turn on level. Therefore, the third transistor T3 and the fourth transistor T4 are turned on to apply the initialization voltage Vini to the third node N3 and the second node N2. As a result, the gate electrode and the drain electrode of the driving transistor T1 are initialized to the initialization voltage Vini. In the refresh frame, the initialization voltage Vini may be selected in a voltage range which is sufficiently less than an operating voltage of the organic light emitting diode OLED and may be set to a voltage equal to or less than a low potential driving voltage VSSEL.

Referring to FIGS. 3 and 4C, during a sampling period of the refresh frame, the first scan signal SC1(n) is a high level which is a turn on level and the second scan signal SC2(n) is a low level which is a turn on level. During the sampling period of the refresh frame, the first scan signal SC1(n) is a high level which is a turn on level, an odd-numbered second scan signal SC2_Odd(n) is a low level which is a turn on level, and an even-numbered second scan signal SC2_Even(n) is a low level which is a turn on level. In FIG 3, in the refresh frame, the odd-numbered second scan signal SC2_Odd(n) and the even-numbered second scan signal SC2_Even(n) which are second scan signals SC2(n) are illustrated by a waveform including one pulse. However, the present disclosure is not limited thereto and the odd-numbered second scan signal SC2_Odd(n) and the even-numbered second scan signal SC2_Even(n) which are second scan signals SC2(n) may have a waveform including a plurality of pulses.

Therefore, during the sampling period, the second transistor T2 is turned on so that the data voltage Vdata is applied to the first node N1. Further, the third transistor T3 is also turned on so that the driving transistor T1 forms a diode connection. Therefore, the gate electrode and the drain electrode of the driving transistor T1 are shorted so that the driving transistor T1 operates as a diode. During the sampling period, a current Ids flows between the source and the drain of the driving transistor T1. The gate electrode and the drain electrode of the driving transistor T1 are diode-connected, so that the voltage of the second node N2 rises by the current flowing from the source electrode to the drain electrode until the gate-source voltage Vgs of the driving transistor T1 becomes Vth. During the sampling period, the voltage of the second node N2 is charged with a voltage Vdata-|Vth| corresponding to the difference between the data voltage Vdata and the threshold voltage Vth of the driving transistor T1.

Further, during the sampling period of the refresh frame, the second scan signal SC2(n) is a low level which is a turn on level, so that the seventh transistor T7 is turned on to apply the reset voltage VAR to the fourth node N4. That is, the anode electrode of the organic light emitting diode OLED is reset to the reset voltage VAR.

Further, in the refresh frame, when the odd-numbered second scan signal SC2_Odd(n) and the even-numbered second scan signal SC2_Even(n) which are second scan signals SC2(n) have a waveform including a plurality of pulses, the second transistor T2 is turned on to apply the data voltage Vdata to the first node N1. Therefore, also in the refresh frame, the bias stress is applied to the first node N1 which is the source electrode of the driving transistor T1 to relieve the hysteresis of the driving transistor T1.

Referring to FIGS. 3 and 4D, during the emission period of the refresh frame, the emission signal EM(n) is a low level which is a turn on level. Therefore, the fifth transistor T5 is turned on to apply the high potential driving voltage VDDEL to the first node N1. The sixth transistor T6 is also turned on to form a current path of the third node N3 and the fourth node N4. As a result, a driving current Ioled passing through the source electrode and the drain electrode of the driving transistor T1 is applied to the organic light emitting diode OLED.

A relational expression of the driving current Ioled flowing through the organic light emitting diode OLED during the emission period is represented by the following Equation 1. Ioled = k/2(Vgs + |Vth|)2 = k/2(Vg - Vs + |Vth|)2 = k/2(Vdata - |Vth| - VDD + |Vth|)2 = k/2(Vdata - VDD)2

In Equation 1, k/2 is a proportional constant determined by an electron mobility of the driving transistor T1, a parasitic capacitance, a channel capacity, and the like.

As seen from Equation 1, it is understood that in the relational expression of the driving current Ioled, a component of the threshold voltage Vth of the driving transistor T1 is eliminated so that even though in the display device of the present disclosure, the threshold voltage Vth changes, the driving current Ioled does not change. As described above, the display device of the present disclosure may program the data voltage regardless of the variation of the threshold voltage Vth during the sampling period.

As described above, the anode electrode of the organic light emitting diode OLED is reset to the reset voltage VAR in both the stress period of the anode reset frame and the sampling period of the refresh frame.

As a result, in the organic light emitting display device according to the exemplary embodiment of the present disclosure, the anode electrode of the organic light emitting diode OLED may be periodically reset during the refresh frame and the reset frame. Accordingly, the consistent rising of the voltage of the anode electrode of the organic light emitting diode OLED due to the leakage current is suppressed even in the driving at a low frequency so that the anode electrode of the organic light emitting diode OLED may maintain a constant voltage level. Accordingly, even though the driving frequency is switched to a low frequency, the luminance variance of the organic light emitting display device is reduced so that the image quality may be increased.

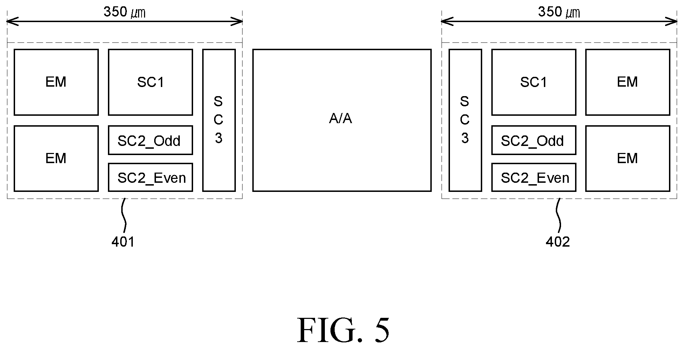

FIG. 5 is a view illustrating a gate driver of an organic light emitting display device according to an exemplary embodiment of the present disclosure.

For example, in order to apply the on bias stress to the driving transistor, in the organic light emitting display device, a separate stage which swings an initialization voltage may be included in the gate driver to increase the initialization voltage from a low level to a high level even in one frame. In this case, in order to apply the on bias stress to the gate driver, the organic light emitting display device includes a separate stage which swings the initialization voltage, which results in the increase of the bezel and when the separate stage is driven, the power consumption may also be increased.

However, the organic light emitting display device according to the exemplary embodiment of the present disclosure uses a high level of data voltage Vdata to apply the on bias stress to the driving transistor T1. Accordingly, the organic light emitting display device according to the exemplary embodiment of the present disclosure does not need to include a separate stage which swings the initialization voltage in the gate driver to apply the on bias stress.

Therefore, as illustrated in FIG. 5, both the first gate driver 401 disposed at the left side of the display area A/A and the second gate driver 402 disposed at the right side of the display area A/A include only two emission signal stages EM, a first scan signal stage SC1, an odd-numbered second scan signal stage SC2_Odd, an even-numbered second scan signal stage SC2_Even, and a third scan signal stage SC3. However, the first gate driver 401 and the second gate driver 402 may not include a separate stage which swings the initialization voltage to apply the on bias stress.

Accordingly, a width of each of the first gate driver 401 and the second gate driver 402 may be reduced from 400 µm to 350 µm so that the width of the bezel may be reduced. Further, there is no need to drive a separate stage for applying the on bias stress, so that the power consumption may also be reduced.

Additionally, in the organic light emitting display device according to the exemplary embodiment of the present disclosure, there is no need to form a separate stage for applying the on bias stress, so that the manufacturing process yield of the gate driver may be improved.

Hereinafter, an organic light emitting display device according to another exemplary embodiment of the present disclosure will be described. As compared with the organic light emitting display device according to the exemplary embodiment of the present disclosure, the difference of an organic light emitting display device according to another exemplary embodiment of the present disclosure is only the fourth transistor and the initialization voltage, but other technical features are the same.

### <Another exemplary embodiment of present disclosure - Example 2>

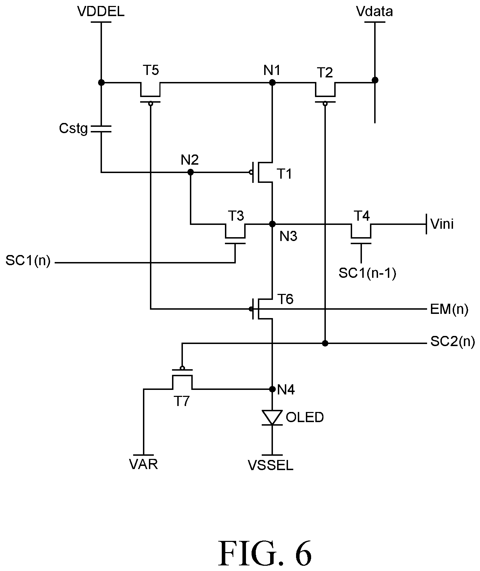

FIG. 6 is a circuit diagram illustrating a pixel of an organic light emitting display device according to another exemplary embodiment of the present disclosure.

Each pixel P includes an organic light emitting diode OLED, a driving transistor T1, second to seventh transistors T2 to T7, and a storage capacitor Cstg.

The organic light emitting diode OLED emits light by a driving current supplied from the driving transistor T1. A multilayered organic compound layer is formed between the anode electrode and the cathode electrode of the organic light emitting diode OLED. The organic compound layer includes at least one of a hole transfer layer and an electron transfer layer, and an emission layer (EML). Here, the hole transfer layer is a layer which injects or transfers holes to the emission layer and for example, may include a hole injection layer (HIL), a hole transport layer (HTL), and an electron blocking layer (EBL). The electron transfer layer is a layer which injects or transfers the electrons to the emission layer and for example, may include an electron transport layer (ETL), an electron injection layer (EIL), and a hole blocking layer (HBL). An anode electrode of the organic light emitting diode OLED is connected to a fourth node N4 and a cathode electrode of the organic light emitting diode is connected to an input terminal of a low potential driving voltage VSSEL.

The driving transistor T1 controls a driving current applied to the organic light emitting diode OLED in accordance with a source-gate voltage Vsg. The driving transistor T1 may be a p-type MOSFET (PMOS) and a low temperature polycrystalline silicon (LTPS) thin film transistor. A source electrode of the driving transistor T1 is connected to a first node N1, a gate electrode is connected to a second node N2, and a drain electrode is connected to a third node N3. The driving transistor T1 may be referred to as a first transistor.

The second transistor T2 applies a data voltage Vdata supplied from a data line to a first node N1 which is the source electrode of the driving transistor T1. The second transistor T2 may be a p-type MOSFET (PMOS) and a low temperature polycrystalline silicon (LTPS) thin film transistor. The second transistor T2 includes a source electrode connected to the data line, a drain electrode connected to the first node N1, and a gate electrode connected to a second scan signal line which transmits a second scan signal SC2(n). Accordingly, the second transistor T2 applies a data voltage Vdata supplied from the data line to the first node N1 which is the source electrode of the driving transistor T1, in response to a low level of second scan signal SC2(n) which is a turn on level.

The third transistor T3 forms a diode connection between a gate electrode and a drain electrode of the driving transistor T1. The third transistor T3 may be an n-type MOSFET NMOS and an oxide thin film transistor to reduce a leakage current. The third transistor T3 includes a drain electrode connected to the third node N3, a source electrode connected to the second node N2, and a gate electrode connected to a first scan signal line which transmits a first scan signal SC1(n). Therefore, the third transistor T3 forms a diode connection between the gate electrode and the drain electrode of the driving transistor T1 in response to a high level of the first scan signal SC1(n) which is a turn on level.

The fourth transistor T4 applies an initialization voltage Vini to the third node N3 which is the drain electrode of the driving transistor T1. The fourth transistor T4 may be an n-type MOSFET (NMOS) and an oxide thin film transistor to reduce a leakage current. The fourth transistor T4 includes a source electrode connected to an initialization voltage line which transmits an initialization voltage Vini, a drain electrode connected to the third node N3, and a gate electrode connected to a first scan signal line of a previous stage which transmits a first scan signal SC1(n - 1) of the previous stage. Accordingly, the fourth transistor T4 applies the initialization voltage Vini to the third node N3 which is the drain electrode of the driving transistor T1, in response to a high level of first scan signal SC1(n - 1) of the previous stage which is a turn on level.

The fifth transistor T5 applies a high potential driving voltage VDDEL to the first node N1 which is the source electrode of the driving transistor T1. The fifth transistor T5 may be a p-type MOSFET (PMOS) and a low temperature polycrystalline silicon (LTPS) thin film transistor. The fifth transistor T5 includes a source electrode connected to a high potential driving voltage line which transmits a high potential driving voltage VDDEL, a drain electrode connected to the first node N1, and a gate electrode connected to an emission signal line which transmits an emission signal EM(n). Accordingly, the fifth transistor T5 applies the high potential driving voltage VDDEL to the first node N1 which is the source electrode of the driving transistor T1, in response to a low level of emission signal EM(n) which is a turn on level.

The sixth transistor T6 forms a current path between the driving transistor T1 and the organic light emitting diode OLED. The sixth transistor T6 may be a p-type MOSFET (PMOS) and a low temperature polycrystalline silicon (LTPS) thin film transistor. The sixth transistor T6 includes a source electrode connected to the third node N3, a drain electrode connected to the fourth node N4, and a gate electrode connected to the emission signal line which transmits an emission signal EM(n). The sixth transistor T6 forms a current path between the third node N3 which is the source electrode of the sixth transistor T6 and the fourth node N4 which is the drain electrode of the sixth transistor T6, in response to the emission signal EM(n). Accordingly, the sixth transistor T6 forms a current path between the driving transistor T1 and the organic light emitting diode OLED in response to a low level of emission signal EM(n) which is a turn on level.

The seventh transistor T7 applies a reset voltage VAR to the fourth anode N4 which is an anode of the organic light emitting diode. The seventh transistor T7 may be a p-type MOSFET (PMOS) and a low temperature polycrystalline silicon (LTPS) thin film transistor. The seventh transistor T7 includes a source electrode connected to the reset voltage line which transmits the reset voltage VAR, a drain electrode connected to the fourth node N4, and a gate electrode connected to a second scan signal line which transmits a second scan signal SC2(n). Accordingly, the seventh transistor T7 applies the reset voltage VAR to the fourth node N4 which is the anode of the light emitting diode, in response to a low level of second scan signal SC2(n) which is a turn on level.

The storage capacitor Cstg holds a data voltage Vdata stored in each pixel for one frame. The storage capacitor Cstg includes a first electrode connected to the second node N2 and a second electrode connected to the high potential driving voltage line which transmits a high potential driving voltage VDDEL. That is, one electrode of the storage capacitor Cstg is connected to the gate electrode of the driving transistor T1 and the other electrode of the storage capacitor Cstg is connected to the high potential driving voltage line which transmits a high potential driving voltage VDDEL.

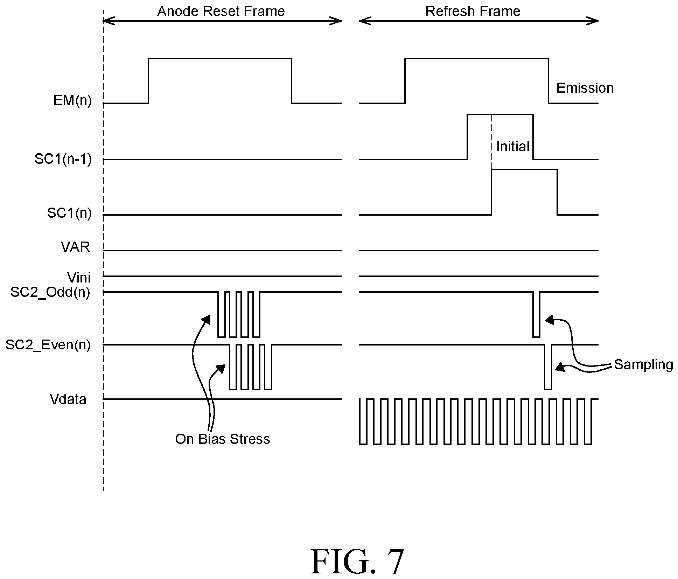

FIG. 7 is a waveform illustrating a signal which is applied to a pixel of an organic light emitting display device during one frame according to another exemplary embodiment of the present disclosure.

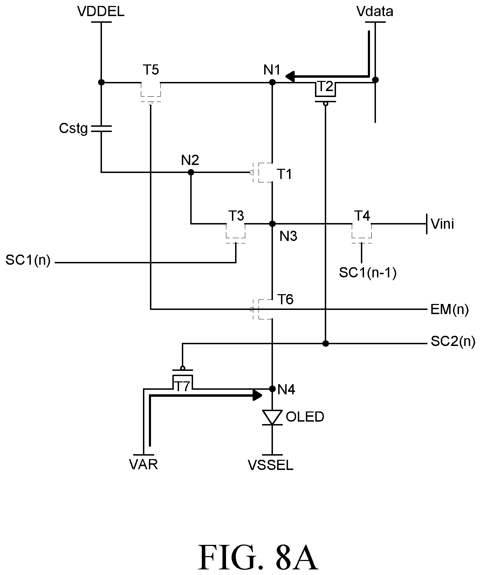

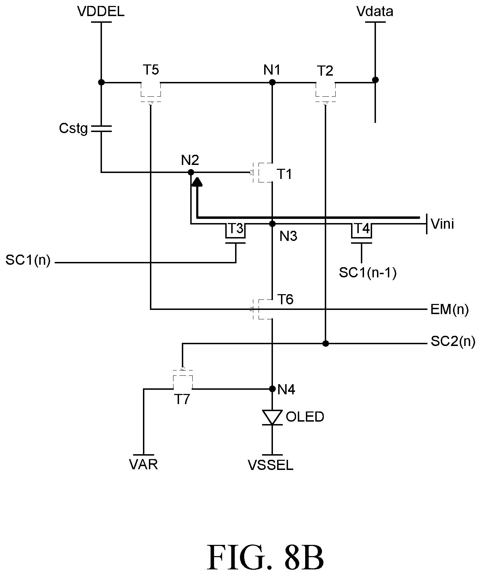

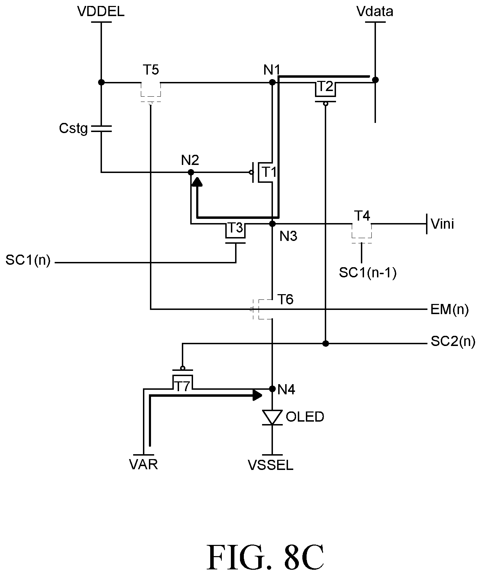

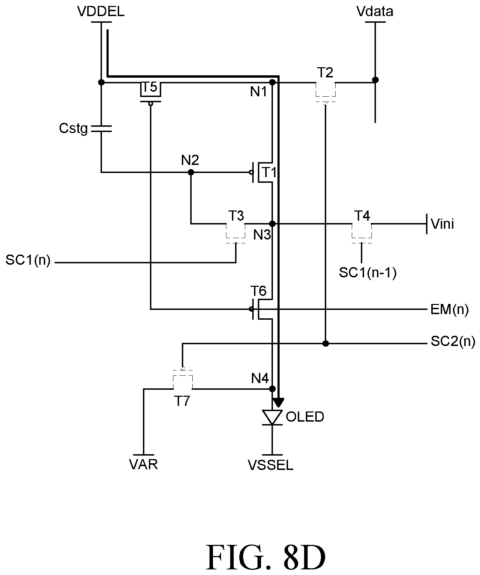

FIG. 8A is a circuit diagram of a pixel of an organic light emitting display device during an on bias stress period according to another exemplary embodiment of the present disclosure. FIG. 8B is a circuit diagram of a pixel of an organic light emitting display device during an initial period according to another exemplary embodiment of the present disclosure. FIG. 8C is a circuit diagram of a pixel of an organic light emitting display device during a sampling period according to another exemplary embodiment of the present disclosure. FIG. 8D is a circuit diagram of a pixel of an organic light emitting display device during an emission period according to another exemplary embodiment of the present disclosure.

The driving of the pixel of the organic light emitting display device according to another exemplary embodiment of the present disclosure will be described with reference to FIGS. 6 to 8D, as follows.

The organic light emitting display device according to another exemplary embodiment of the present disclosure may also be driven to be divided into a refresh frame and an anode reset frame. In the refresh frame, the data voltage Vdata is programmed in each pixel P and the organic light emitting diode OLED emits light. The anode reset frame may be a vertical blank frame and the anode electrode of the organic light emitting diode OLED is reset during the anode reset frame.

In the organic light emitting display device according to another exemplary embodiment of the present disclosure, the anode reset frame may include a plurality of stress periods (on bias stress). The stress period (on bias stress) is a period in which a bias stress is applied to the first node N1 which is the source electrode of the driving transistor T1. Further, during the stress period, the anode electrode of the organic light emitting diode OLED may be reset. Further, as illustrated in FIG. 7, during the anode reset frame, the reset voltage VAR and the initialization voltage Vini are low levels and the data voltage Vdata is a high level.

In the organic light emitting display device according to another exemplary embodiment of the present disclosure, the refresh frame may be divided into an initial period, a sampling period, and an emission period. The initial period is a period in which the voltage of the third node N3 which is the drain electrode of the driving transistor T1 is initialized. The sampling period is a period in which a threshold voltage Vth of the driving transistor T1 is sampled and the data voltage Vdata is programmed. The emission period is a period in which the organic light emitting diode OLED emits light in accordance with the driving current by the source-gate voltage of the programmed driving transistor T1. As illustrated in FIG. 7, during the refresh frame, the reset voltage VAR and the initialization voltage Vini are low levels.

Specifically, referring to FIGS. 7 and 8A, during the stress period (on bias stress) of the anode reset frame, the second scan signal SC2(n) is a low level which is a turn on level. That is, during the stress period (on bias stress) of the anode reset frame, an odd-numbered second scan signal SC2_Odd(n) is a low level which is a turn on level and an even-numbered second scan signal SC2_Even(n) is a low level which is a turn on level. In other words, in the anode reset frame including a plurality of stress periods (on bias stress), the odd-numbered second scan signal SC2_Odd(n) and the even-numbered second scan signal SC2_Even(n) which are second scan signals SC2(n) may have a waveform including a plurality of pulses. In the anode reset frame including a plurality of stress periods (on bias stress), the data voltage Vdata is always a high level.

Therefore, the seventh transistor T7 is turned on to apply the reset voltage VAR to the fourth node N4. That is, the anode electrode of the organic light emitting diode OLED is reset to the reset voltage VAR.

Therefore, the second transistor T2 is turned on to apply a high level of data voltage Vdata to the first node N1. The high level of data voltage Vdata may be selected in a voltage range which is sufficiently higher than an operating voltage of the organic light emitting diode OLED and may be set to a voltage equal to or less than a high potential driving voltage VDDEL. That is, during the stress period (on bias stress), the on bias stress is applied to the first node N1 which is the source electrode of the driving transistor T1 to drop the gate-source voltage Vgs of the driving transistor T1. Accordingly, during the stress period (on bias stress), the source-drain current Ids of the driving transistor T1 flows to relieve the hysteresis of the driving transistor T1.

Referring to FIGS. 7 and 8B, during an initial period of the refresh frame, the first scan signal SC1(n) is a high level which is a turn on level and the first scan signal SC1(n - 1) of the previous stage is a high level which is a turn on level. Therefore, the third transistor T3 and the fourth transistor T4 are turned on to apply the initialization voltage Vini to the third node N3 and the second node N2. As a result, the gate electrode and the drain electrode of the driving transistor T1 are initialized to the initialization voltage Vini. In the refresh frame, the initialization voltage Vini may be selected in a voltage range which is sufficiently less than an operating voltage of the organic light emitting diode OLED and may be set to a voltage equal to or less than a low potential driving voltage VSSEL.

Referring to FIGS. 7 and 8C, during a sampling period of the refresh frame, the first scan signal SC1(n) is a high level which is a turn on level and the second scan signal SC2(n) is a low level which is a turn on level. During the sampling period of the refresh frame, the first scan signal SC1(n) is a high level which is a turn on level, an odd-numbered second scan signal SC2_Odd(n) is a low level which is a turn on level, and an even-numbered second scan signal SC2_Even(n) is a low level which is a turn on level. In FIG 7, in the refresh frame, the odd-numbered second scan signal SC2_Odd(n) and the even-numbered second scan signal SC2_Even(n) which are second scan signals SC2(n) are illustrated by a waveform including one pulse. However, the present disclosure is not limited thereto and the odd-numbered second scan signal SC2_Odd(n) and the even-numbered second scan signal SC2_Even(n) which are second scan signals SC2(n) may have a waveform including a plurality of pulses.

Therefore, during the sampling period, the second transistor T2 is turned on so that the data voltage Vdata is applied to the first node N1. Further, the third transistor T3 is also turned on so that the driving transistor T1 is diode-connected. Therefore, the gate electrode and the drain electrode of the driving transistor T1 are shorted so that the driving transistor T1 operates as a diode. During the sampling period, a current Ids flows between the source and the drain of the driving transistor T1. The gate electrode and the drain electrode of the driving transistor T1 are diode-connected, so that the voltage of the second node N2 rises by the current flowing from the source electrode to the drain electrode until the gate-source voltage Vgs of the driving transistor T1 becomes Vth. During the sampling period, the voltage of the second node N2 is charged with a voltage Vdata-|Vth| corresponding to the difference between the data voltage Vdata and the threshold voltage Vth of the driving transistor T1.

Further, during the sampling period of the refresh frame, the second scan signal SC2(n) is a low level which is a turn on level, so that the seventh transistor T7 is turned on to apply the reset voltage VAR to the fourth node N4. That is, the anode electrode of the organic light emitting diode OLED is reset to the reset voltage VAR.

Further, in the refresh frame, when the odd-numbered second scan signal SC2_Odd(n) and the even-numbered second scan signal SC2_Even(n) which are second scan signals SC2(n) have a waveform including a plurality of pulses, the second transistor T2 is turned on to apply the data voltage Vdata to the first node N1. Therefore, also in the refresh frame, the bias stress is applied to the first node N1 which is the source electrode of the driving transistor T1 to relieve the hysteresis of the driving transistor T1.

Referring to FIGS. 7 and 8D, during the emission period of the refresh frame, the emission signal EM(n) is a low level which is a turn on level. Therefore, the fifth transistor T5 is turned on to apply the high potential driving voltage VDDEL to the first node N1. The sixth transistor T6 is also turned on to form a current path of the third node N3 and the fourth node N4. As a result, a driving current Ioled passing through the source electrode and the drain electrode of the driving transistor T1 is applied to the organic light emitting diode OLED.

A relational expression of the driving current Ioled flowing through the organic light emitting diode OLED during the emission period is represented by the above-described Equation 1.

As seen from Equation 1, it is understood that in the relational expression of the driving current Ioled, a component of the threshold voltage Vth of the driving transistor T1 is eliminated so that even though in the display device of the present disclosure, the threshold voltage Vth changes, the driving current Ioled does not change. As described above, the display device of the present disclosure may program the data voltage regardless of the variation of the threshold voltage Vth during the sampling period.

As described above, the anode electrode of the organic light emitting diode OLED is reset to the reset voltage VAR in both the stress period of the anode reset frame and the sampling period of the refresh frame.

As a result, also in the organic light emitting display device according to another exemplary embodiment of the present disclosure, the anode electrode of the organic light emitting diode OLED may be periodically reset during the refresh frame and the reset frame. Accordingly, the consistent rising of the voltage of the anode electrode of the organic light emitting diode OLED due to the leakage current is suppressed even in the driving at a low frequency so that the anode electrode of the organic light emitting diode OLED may maintain a constant voltage level. Accordingly, even though the driving frequency is switched to a low frequency, the luminance variance of the organic light emitting display device is reduced so that the image quality may be increased.

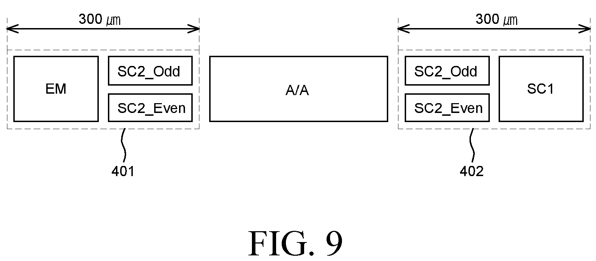

FIG. 9 is a view illustrating a gate driver of an organic light emitting display device according to another exemplary embodiment of the present disclosure.

The organic light emitting display device according to another exemplary embodiment of the present disclosure uses a high level of data voltage Vdata to apply the on bias stress to the driving transistor T1. Accordingly, the organic light emitting display device according to another exemplary embodiment of the present disclosure does not need to include a separate stage which swings the initialization voltage in the gate driver to apply the on bias stress.

Moreover, as illustrated in FIG. 9, the first gate driver 401 disposed at the left side of the display area A/A includes only the emission signal stage EM, an odd-numbered second scan signal stage SC2_Odd and an even-numbered second scan signal stage SC2_Even, and the second gate driver 402 disposed at the right side of the display area A/A include only a first scan signal stage SC1, an odd-numbered second scan signal stage SC2_Odd and an even-numbered second scan signal stage SC2_Even. However, the first gate driver 401 and the second gate driver 402 may not include a third scan signal stage.

Accordingly, a width of each of the first gate driver 401 and the second gate driver 402 may be reduced from 350 µm to 300 µm as compared with the organic light emitting display device according to the exemplary embodiment of the present disclosure so that the width of the bezel may be further reduced. Further, there is no need to drive a third scan signal stage, so that the power consumption may also be reduced.

Hereinafter, an organic light emitting display device according to still another exemplary embodiment (Example 3) of the present disclosure will be described. Only difference between an organic light emitting display device according to still another exemplary embodiment (Example 3) of the present disclosure and the organic light emitting display device according to the exemplary embodiment of the present disclosure is a drain electrode connection relationship of the fourth transistor. Other technical features are the same. Therefore, a signal applied to a pixel of the organic light emitting display device according to still another exemplary embodiment (Example 3) of the present disclosure and a signal applied to a pixel of the organic light emitting display device according to the exemplary embodiment of the present disclosure are the same. Therefore, the organic light emitting display device according to still another exemplary embodiment (Example 3) of the present disclosure will be described using a waveform of FIG. 3.

### <Still another exemplary embodiment of present disclosure - Example 3>

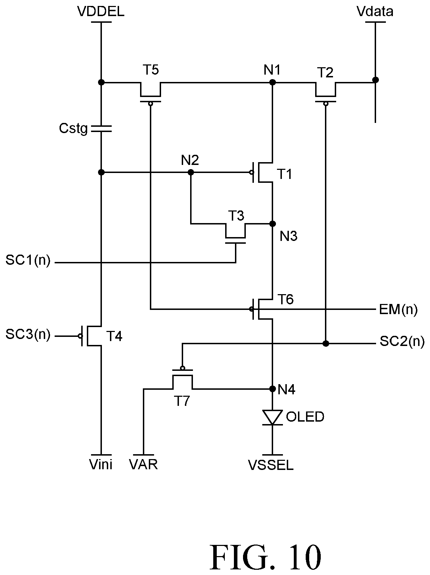

FIG. 10 is a circuit diagram illustrating a pixel of an organic light emitting display device according to still another exemplary embodiment (Example 3) of the present disclosure.

Each pixel P includes an organic light emitting diode OLED, a driving transistor T1, second to seventh transistors T2 to T7, and a storage capacitor Cstg.

The organic light emitting diode OLED emits light by a driving current supplied from the driving transistor T1. A multilayered organic compound layer is formed between the anode electrode and the cathode electrode of the organic light emitting diode OLED. The organic compound layer includes at least one of a hole transfer layer and an electron transfer layer, and an emission layer (EML). Here, the hole transfer layer is a layer which injects or transfers holes to the emission layer and for example, may include a hole injection layer (HIL), a hole transport layer (HTL), and an electron blocking layer (EBL). The electron transfer layer is a layer which injects or transfers the electrons to the emission layer and for example, may include an electron transport layer (ETL), an electron injection layer (EIL), and a hole blocking layer (HBL). An anode electrode of the organic light emitting diode OLED is connected to a fourth node N4 and a cathode electrode of the organic light emitting diode is connected to an input terminal of a low potential driving voltage VSSEL.

The driving transistor T1 controls a driving current applied to the organic light emitting diode OLED in accordance with a source-gate voltage Vsg. The driving transistor T1 may be a p-type MOSFET (PMOS) and a low temperature polycrystalline silicon (LTPS) thin film transistor. A source electrode of the driving transistor T1 is connected to a first node N1, a gate electrode is connected to a second node N2, and a drain electrode is connected to a third node N3. The driving transistor T1 may be referred to as a first transistor.

The second transistor T2 applies a data voltage Vdata supplied from a data line to a first node N1 which is the source electrode of the driving transistor T1. The second transistor T2 may be a p-type MOSFET (PMOS) and a low temperature polycrystalline silicon (LTPS) thin film transistor. The second transistor T2 includes a source electrode connected to the data line, a drain electrode connected to the first node N1, and a gate electrode connected to a second scan signal line which transmits a second scan signal SC2(n). Accordingly, the second transistor T2 applies a data voltage Vdata supplied from the data line to the first node N1 which is the source electrode of the driving transistor T1, in response to a low level of second scan signal SC2(n) which is a turn on level.

The third transistor T3 forms a diode connection between a gate electrode and a drain electrode of the driving transistor T1. The third transistor T3 may be an n-type MOSFET NMOS and an oxide thin film transistor to reduce a leakage current. The third transistor T3 includes a drain electrode connected to the third node N3, a source electrode connected to the second node N2, and a gate electrode connected to a first scan signal line which transmits a first scan signal SC1(n). Therefore, the third transistor T3 forms a diode connection between the gate electrode and the drain electrode of the driving transistor T1 in response to the first scan signal SC1(n) of a high level which is a turn on level.

The fourth transistor T4 applies an initialization voltage Vini to the second node N2 which is the gate electrode of the driving transistor T1. The fourth transistor T4 may be a p-type MOSFET (PMOS) and a low temperature polycrystalline silicon (LTPS) thin film transistor. The fourth transistor T4 includes a source electrode connected to an initialization voltage line which transmits an initialization voltage Vini, a drain electrode connected to the second node N2, and a gate electrode connected to a third scan signal line which transmits a third scan signal SC3(n). Accordingly, the fourth transistor T4 applies the initialization voltage Vini to the second node N2 which is the gate electrode of the driving transistor T1, in response to a low level of third scan signal SC3(n) which is a turn on level.

The fifth transistor T5 applies a high potential driving voltage VDDEL to the first node N1 which is the source electrode of the driving transistor T1. The fifth transistor T5 may be a p-type MOSFET (PMOS) and a low temperature polycrystalline silicon (LTPS) thin film transistor. The fifth transistor T5 includes a source electrode connected to a high potential driving voltage line which transmits a high potential driving voltage VDDEL, a drain electrode connected to the first node N1, and a gate electrode connected to an emission signal line which transmits an emission signal EM(n). Accordingly, the fifth transistor T5 applies the high potential driving voltage VDDEL to the first node N1 which is the source electrode of the driving transistor T1, in response to a low level of emission signal EM(n) which is a turn on level.

The sixth transistor T6 forms a current path between the driving transistor T1 and the organic light emitting diode OLED. The sixth transistor T6 may be a p-type MOSFET (PMOS) and a low temperature polycrystalline silicon (LTPS) thin film transistor. The sixth transistor T6 includes a source electrode connected to the third node N3, a drain electrode connected to the fourth node N4, and a gate electrode connected to the emission signal line which transmits an emission signal EM(n). The sixth transistor T6 forms a current path between the third node N3 which is the source electrode of the sixth transistor T6 and the fourth node N4 which is the drain electrode of the sixth transistor T6, in response to the emission signal EM(n). Accordingly, the sixth transistor T6 forms a current path between the driving transistor T1 and the organic light emitting diode OLED in response to a low level of emission signal EM(n) which is a turn on level.

The seventh transistor T7 applies a reset voltage VAR to the fourth anode N4 which is an anode of the organic light emitting diode. The seventh transistor T7 may be a p-type MOSFET (PMOS) and a low temperature polycrystalline silicon (LTPS) thin film transistor. The seventh transistor T7 includes a source electrode connected to the reset voltage line which transmits the reset voltage VAR, a drain electrode connected to the fourth node N4, and a gate electrode connected to a second scan signal line which transmits a second scan signal SC2(n). Accordingly, the seventh transistor T7 applies the reset voltage VAR to the fourth node N4 which is the anode of the organic light emitting diode, in response to a low level of second scan signal SC2(n) which is a turn on level.

The storage capacitor Cstg holds a data voltage Vdata stored in each pixel for one frame. The storage capacitor Cstg includes a first electrode connected to the second node N2 and a second electrode connected to the high potential driving voltage line which transmits a high potential driving voltage VDDEL. That is, one electrode of the storage capacitor Cstg is connected to the gate electrode of the driving transistor T1 and the other electrode of the storage capacitor Cstg is connected to the high potential driving voltage line which transmits a high potential driving voltage VDDEL.

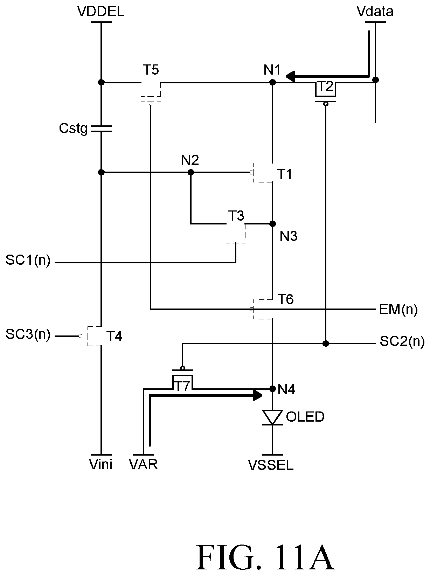

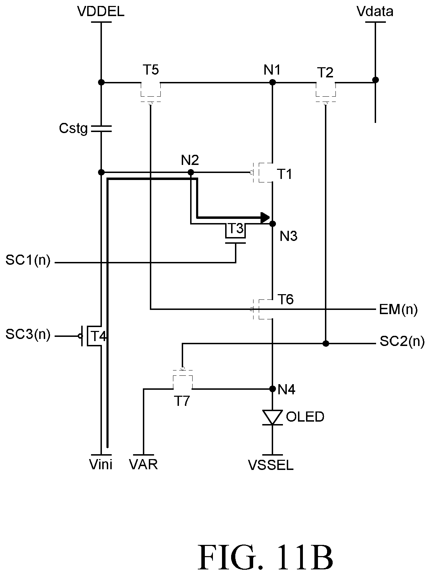

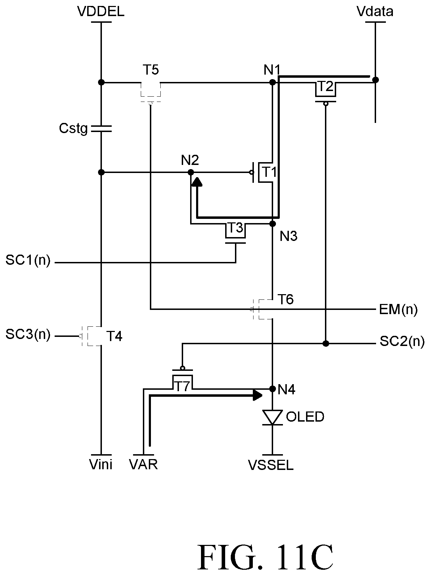

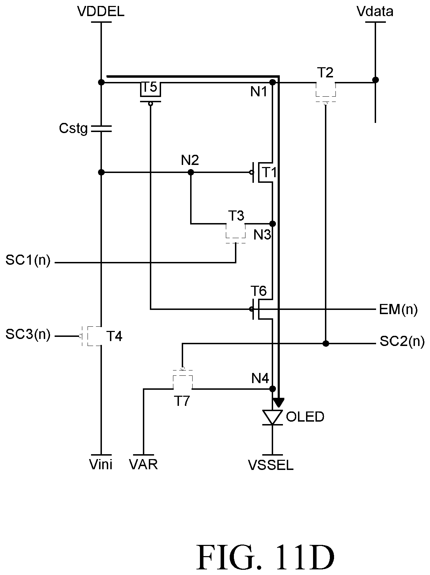

FIG. 11A is a circuit diagram of a pixel of an organic light emitting display device during an on bias stress period according to still another exemplary embodiment (Example 3) of the present disclosure. FIG. 11B is a circuit diagram of a pixel of an organic light emitting display device during an initial period according to still another exemplary embodiment (Example 3) of the present disclosure. FIG. 11C is a circuit diagram of a pixel of an organic light emitting display device during a sampling period according to still another exemplary embodiment (Example 3) of the present disclosure. FIG. 11D is a circuit diagram of a pixel of an organic light emitting display device during an emission period according to still another exemplary embodiment (Example 3) of the present disclosure.

The driving of the pixel of the organic light emitting display device according to still another exemplary embodiment (Example 3) of the present disclosure will be described with reference to FIGS. 10 to 11D, as follows.

The organic light emitting display device according to still another exemplary embodiment (Example 3) of the present disclosure may be driven to be divided into a refresh frame and an anode reset frame. In the refresh frame, the data voltage Vdata is programmed in each pixel P and the organic light emitting diode OLED emits light. The anode reset frame may be a vertical blank frame and the anode electrode of the organic light emitting diode OLED is reset during the anode reset frame.

In the organic light emitting display device according to still another exemplary embodiment (Example 3) of the present disclosure, the anode reset frame may include a plurality of stress periods (on bias stress). The stress period (on bias stress) is a period in which a bias stress is applied to the first node N1 which is the source electrode of the driving transistor T1. Further, during the stress period, the anode electrode of the organic light emitting diode OLED may be reset. Further, as illustrated in FIG. 3, during the anode reset frame, the reset voltage VAR is a low level and the initialization voltage Vini and the data voltage Vdata are high levels.

In the organic light emitting display device according to still another exemplary embodiment (Example 3) of the present disclosure, the refresh frame may be divided into an initial period, a sampling period, and an emission period. The initial period is a period in which the voltage of the second node N2 which is the gate electrode of the driving transistor T1 is initialized. The sampling period is a period in which a threshold voltage Vth of the driving transistor T1 is sampled and the data voltage Vdata is programmed. The emission period is a period in which the organic light emitting diode OLED emits light in accordance with the driving current by the source-gate voltage of the programmed driving transistor T1. As illustrated in FIG. 3, during the refresh frame, the reset voltage VAR and the initialization voltage Vini are low levels.

Specifically, referring to FIGS. 3 and 11A, during the stress period (on bias stress) of the anode reset frame, the second scan signal SC2(n) is a low level which is a turn on level. That is, during the stress period (on bias stress) of the anode reset frame, an odd-numbered second scan signal SC2_Odd(n) is a low level which is a turn on level and an even-numbered second scan signal SC2_Even(n) is a low level which is a turn on level. In other words, in the anode reset frame including a plurality of stress periods (on bias stress), the odd-numbered second scan signal SC2_Odd(n) and the even-numbered second scan signal SC2_Even(n) which are second scan signals SC2(n) may have a waveform including a plurality of pulses. In the anode reset frame including a plurality of stress periods (on bias stress), the data voltage Vdata is always a high level.

Therefore, the seventh transistor T7 is turned on to apply the reset voltage VAR to the fourth node N4. That is, the anode electrode of the organic light emitting diode OLED is reset to the reset voltage VAR.

Therefore, the second transistor T2 is turned on to apply a high level of data voltage Vdata to the first node N1. The high level of data voltage Vdata may be selected in a voltage range which is sufficiently higher than an operating voltage of the organic light emitting diode OLED and may be set to a voltage equal to or less than a high potential driving voltage VDDEL. That is, during the stress period (on bias stress), the on bias stress is applied to the first node N1 which is the source electrode of the driving transistor T1 to drop the gate-source voltage Vgs of the driving transistor T1. Accordingly, during the stress period (on bias stress), the source-drain current Ids of the driving transistor T1 flows to relieve the hysteresis of the driving transistor T1.

In the anode reset frame, the initialization voltage Vini may be a high level. Therefore, a high level of third scan signal SC3(n) is applied to the gate electrode of the fourth transistor T4 and a high level of initialization voltage Vini is applied to the source electrode of the fourth transistor T4 so that a potential difference between the gate electrode and the source electrode of the fourth transistor T4 may be reduced. Accordingly, during the anode reset frame, the leakage current of the fourth transistor T4 may be reduced.

Referring to FIGS. 3 and 11B, during an initial period of the refresh frame, the first scan signal SC1(n) is a high level which is a turn on level and the third scan signal SC3(n) is a low level which is a turn on level. Therefore, the third transistor T3 and the fourth transistor T4 are turned on to apply the initialization voltage Vini to the third node N3 and the second node N2. As a result, the gate electrode and the drain electrode of the driving transistor T1 are initialized to the initialization voltage Vini. In the refresh frame, the initialization voltage Vini may be selected in a voltage range which is sufficiently less than an operating voltage of the organic light emitting diode OLED and may be set to a voltage equal to or less than a low potential driving voltage VSSEL.

Referring to FIGS. 3 and 11C, during a sampling period of the refresh frame, the first scan signal SC1(n) is a high level which is a turn on level and the second scan signal SC2(n) is a low level which is a turn on level. During the sampling period of the refresh frame, the first scan signal SC1(n) is a high level which is a turn on level, an odd-numbered second scan signals SC2_Odd(n) is a low level which is a turn on level, and an even-numbered second scan signal SC2_Even(n) is a low level which is a turn on level. In FIG 3, in the refresh frame, the odd-numbered second scan signals SC2_Odd(n) and the even-numbered second scan signals SC2_Even(n) which are second scan signals SC2(n) are illustrated by a waveform including one pulse. However, the present disclosure is not limited thereto and the odd-numbered second scan signal SC2_Odd(n) and the even-numbered second scan signal SC2_Even(n) which are second scan signals SC2(n) may have a waveform including a plurality of pulses.

Therefore, during the sampling period, the second transistor T2 is turned on so that the data voltage Vdata is applied to the first node N1. Further, the third transistor T3 is also turned on so that the driving transistor T1 is diode-connected. Therefore, the gate electrode and the drain electrode of the driving transistor T1 are shorted so that the driving transistor T1 operates as a diode. During the sampling period, a current Ids flows between the source and the drain of the driving transistor T1. The gate electrode and the drain electrode of the driving transistor T1 are diode-connected, so that the voltage of the second node N2 rises by the current flowing from the source electrode to the drain electrode until the gate-source voltage Vgs of the driving transistor T1 becomes Vth. During the sampling period, the voltage of the second node N2 is charged with a voltage Vdata-|Vth| corresponding to the difference between the data voltage Vdata and the threshold voltage Vth of the driving transistor T1.

Further, during the sampling period of the refresh frame, the second scan signal SC2(n) is a low level which is a turn on level, so that the seventh transistor T7 is turned on to apply the reset voltage VAR to the fourth node N4. That is, the anode electrode of the organic light emitting diode OLED is reset to the reset voltage VAR.

Further, in the refresh frame, when the odd-numbered second scan signal SC2_Odd(n) and the even-numbered second scan signal SC2_Even(n) which are second scan signals SC2(n) have a waveform including a plurality of pulses, the second transistor T2 is turned on to apply the data voltage Vdata to the first node N1. Therefore, also in the refresh frame, the bias stress is applied to the first node N1 which is the source electrode of the driving transistor T1 to relieve the hysteresis of the driving transistor T1.

Referring to FIGS. 3 and 11D, during the emission period of the refresh frame, the emission signal EM(n) is a low level which is a turn on level. Therefore, the fifth transistor T5 is turned on to apply the high potential driving voltage VDDEL to the first node N1. The sixth transistor T6 is also turned on to form a current path of the third node N3 and the fourth node N4. As a result, a driving current Ioled passing through the source electrode and the drain electrode of the driving transistor T1 is applied to the organic light emitting diode OLED.

A relational expression of the driving current Ioled flowing through the organic light emitting diode OLED during the emission period is represented by the above-described Equation 1.

As seen from Equation 1, it is understood that in the relational expression of the driving current Ioled, a component of the threshold voltage Vth of the driving transistor T1 is eliminated so that even though in the display device of the present disclosure, the threshold voltage Vth changes, the driving current Ioled does not change. As described above, the display device of the present disclosure may program the data voltage regardless of the variation of the threshold voltage Vth during the sampling period.

As described above, the anode electrode of the organic light emitting diode OLED is reset to the reset voltage VAR in both the stress period of the anode reset frame and the sampling period of the refresh frame.

As a result, in the organic light emitting display device according to still another exemplary embodiment (Example 3) of the present disclosure, the anode electrode of the organic light emitting diode OLED may be periodically reset during the refresh frame and the reset frame. Accordingly, the consistent rising of the voltage of the anode electrode of the organic light emitting diode OLED due to the leakage current is suppressed even in the driving at a low frequency so that the anode electrode of the organic light emitting diode OLED may maintain a constant voltage level. Accordingly, even though the driving frequency is switched to a low frequency, the luminance variance of the organic light emitting display device is reduced so that the image quality may be increased.

In addition, the organic light emitting display device according to still another exemplary embodiment (Example 3) of the present disclosure uses a high level of data voltage Vdata to apply the on bias stress to the driving transistor T1. Accordingly, the organic light emitting display device according to still another exemplary embodiment (Example 3) of the present disclosure does not need to include a separate stage which swings the initialization voltage in the gate driver to apply the on bias stress.

Therefore, as illustrated in FIG. 5, both the first gate driver 401 disposed at the left side of the display area A/A and the second gate driver 402 disposed at the right side of the display area A/A include only two emission signal stages EM, a first scan signal stage SC1, an odd-numbered second scan signal stage SC2_Odd, an even-numbered second scan signal stage SC2_Even, and a third scan signal stage SC3. However, the first gate driver 401 and the second gate driver 402 may not include a separate stage which swings the initialization voltage to apply the on bias stress.

Accordingly, a width of each of the first gate driver 401 and the second gate driver 402 may be reduced from 400 µm to 350 µm so that the width of the bezel may be reduced. Further, there is no need to drive a separate stage for applying the on bias stress, so that the power consumption may also be reduced.

Additionally, the organic light emitting display device according to still another exemplary embodiment (Example 3) of the present disclosure, there is no need to form a separate stage for the on bias stress, so that the manufacturing process yield of the gate driver may be improved.

Hereinafter, an organic light emitting display device according to still another exemplary embodiment (Example 4) of the present disclosure will be described. As compared with the organic light emitting display device according to still another exemplary embodiment (Example 3) of the present disclosure, the difference of an organic light emitting display device according to still another exemplary embodiment (Example 4) of the present disclosure is only the fourth transistor and the initialization voltage, but other technical features are the same. Therefore, a signal applied to a pixel of the organic light emitting display device according to still another exemplary embodiment (Example 4) of the present disclosure and a signal applied to a pixel of the organic light emitting display device according to another exemplary embodiment (Example 2) of the present disclosure are the same. Therefore, the organic light emitting display device according to still another exemplary embodiment (Example 4) of the present disclosure will be described using a waveform of FIG. 7.

### <Still another exemplary embodiment of present disclosure - Example 4>

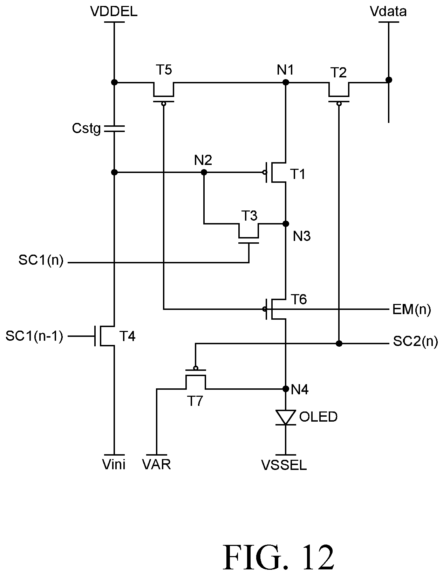

FIG. 12 is a circuit diagram illustrating a pixel of an organic light emitting display device according to still another exemplary embodiment (Example 4) of the present disclosure.

Each pixel P includes an organic light emitting diode OLED, a driving transistor T1, second to seventh transistors T2 to T7, and a storage capacitor Cstg.

The organic light emitting diode OLED emits light by a driving current supplied from the driving transistor T1. A multilayered organic compound layer is formed between the anode electrode and the cathode electrode of the organic light emitting diode OLED. The organic compound layer includes at least one of a hole transfer layer and an electron transfer layer, and an emission layer (EML). Here, the hole transfer layer is a layer which injects or transfers holes to the emission layer and for example, may include a hole injection layer (HIL), a hole transport layer (HTL), and an electron blocking layer (EBL). The electron transfer layer is a layer which injects or transfers the electrons to the emission layer and for example, may include an electron transport layer (ETL), an electron injection layer (EIL), and a hole blocking layer (HBL). An anode electrode of the organic light emitting diode OLED is connected to a fourth node N4 and a cathode electrode of the organic light emitting diode is connected to an input terminal of a low potential driving voltage VSSEL.

The driving transistor T1 controls a driving current applied to the organic light emitting diode OLED in accordance with a source-gate voltage Vsg. The driving transistor T1 may be a p-type MOSFET (PMOS) and a low temperature polycrystalline silicon (LTPS) thin film transistor. A source electrode of the driving transistor T1 is connected to a first node N1, a gate electrode is connected to a second node N2, and a drain electrode is connected to a third node N3. The driving transistor T1 may be referred to as a first transistor.

The second transistor T2 applies a data voltage Vdata supplied from a data line to a first node N1 which is the source electrode of the driving transistor T1. The second transistor T2 may be a p-type MOSFET (PMOS) and a low temperature polycrystalline silicon (LTPS) thin film transistor. The second transistor T2 includes a source electrode connected to the data line, a drain electrode connected to the first node N1, and a gate electrode connected to a second scan signal line which transmits a second scan signal SC2(n). Accordingly, the second transistor T2 applies a data voltage Vdata supplied from the data line to the first node N1 which is the source electrode of the driving transistor T1, in response to a low level of second scan signal SC2(n) which is a turn on level.

The third transistor T3 forms a diode connection between a gate electrode and a drain electrode of the driving transistor T1. The third transistor T3 may be an n-type MOSFET (NMOS) and an oxide thin film transistor to reduce a leakage current. The third transistor T3 includes a drain electrode connected to the third node N3, a source electrode connected to the second node N2, and a gate electrode connected to a first scan signal line which transmits a first scan signal SC1(n). Therefore, the third transistor T3 forms a diode connection between the gate electrode and the drain electrode of the driving transistor T1 in response to a high level of the first scan signal SC1(n) which is a turn on level.

The fourth transistor T4 applies an initialization voltage Vini to the second node N2 which is the gate electrode of the driving transistor T1. The fourth transistor T4 may be an n-type MOSFET (NMOS) and an oxide thin film transistor to reduce a leakage current. The fourth transistor T4 includes a source electrode connected to an initialization voltage line which transmits an initialization voltage Vini, a drain electrode connected to the second node N2, and a gate electrode connected to a first scan signal line of a previous stage which transmits a first scan signal SC1(n - 1) of the previous stage. Accordingly, the fourth transistor T4 applies the initialization voltage Vini to the second node N2 which is the gate electrode of the driving transistor T1, in response to a high level of first scan signal SC1(n - 1) of the previous stage which is a turn on level.

The fifth transistor T5 applies a high potential driving voltage VDDEL to the first node N1 which is the source electrode of the driving transistor T1. The fifth transistor T5 may be a p-type MOSFET (PMOS) and a low temperature polycrystalline silicon (LTPS) thin film transistor. The fifth transistor T5 includes a source electrode connected to a high potential driving voltage line which transmits a high potential driving voltage VDDEL, a drain electrode connected to the first node N1, and a gate electrode connected to an emission signal line which transmits an emission signal EM(n). Accordingly, the fifth transistor T5 applies the high potential driving voltage VDDEL to the first node N1 which is the source electrode of the driving transistor T1, in response to a low level of emission signal EM(n) which is a turn on level.

The sixth transistor T6 forms a current path between the driving transistor T1 and the organic light emitting diode OLED. The sixth transistor T6 may be a p-type MOSFET (PMOS) and a low temperature polycrystalline silicon (LTPS) thin film transistor. The sixth transistor T6 includes a source electrode connected to the third node N3, a drain electrode connected to the fourth node N4, and a gate electrode connected to the emission signal line which transmits an emission signal EM(n). The sixth transistor T6 forms a current path between the third node N3 which is the source electrode of the sixth transistor T6 and the fourth node N4 which is the drain electrode of the sixth transistor T6, in response to the emission signal EM(n). Accordingly, the sixth transistor T6 forms a current path between the driving transistor T1 and the organic light emitting diode OLED in response to a low level of emission signal EM(n) which is a turn on level.

The seventh transistor T7 applies a reset voltage VAR to the fourth anode N4 which is an anode of the organic light emitting diode. The seventh transistor T7 may be a p-type MOSFET (PMOS) and a low temperature polycrystalline silicon (LTPS) thin film transistor. The seventh transistor T7 includes a source electrode connected to the reset voltage line which transmits the reset voltage VAR, a drain electrode connected to the fourth node N4, and a gate electrode connected to a second scan signal line which transmits a second scan signal SC2(n). Accordingly, the seventh transistor T7 applies the reset voltage VAR to the fourth node N4 which is the anode of the organic light emitting diode, in response to a low level of second scan signal SC2(n) which is a turn on level.

The storage capacitor Cstg holds a data voltage Vdata stored in each pixel for one frame. The storage capacitor Cstg includes a first electrode connected to the second node N2 and a second electrode connected to the high potential driving voltage line which transmits a high potential driving voltage VDDEL. That is, one electrode of the storage capacitor Cstg is connected to the gate electrode of the driving transistor T1 and the other electrode of the storage capacitor Cstg is connected to the high potential driving voltage line VDL which transmits a high potential driving voltage VDDEL.

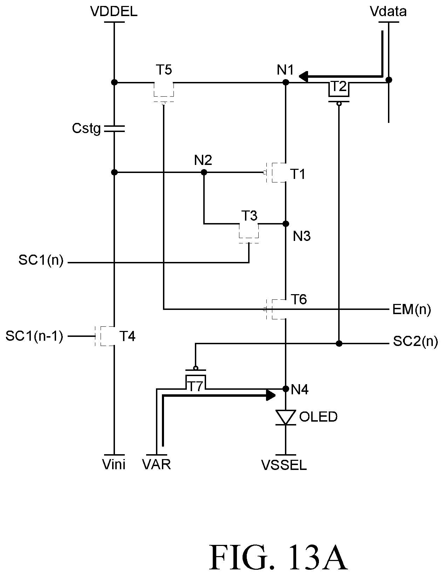

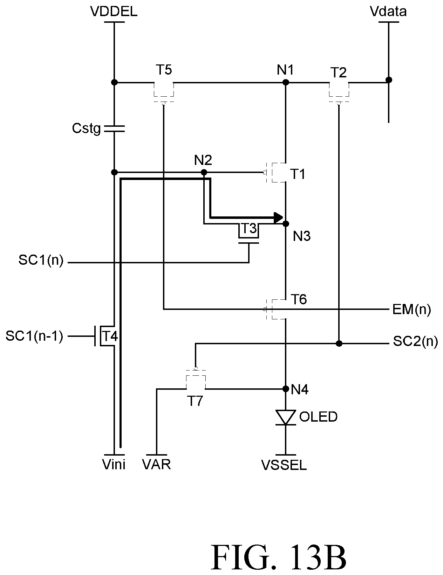

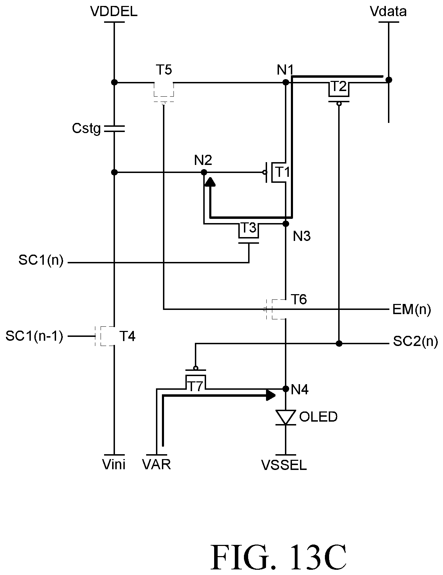

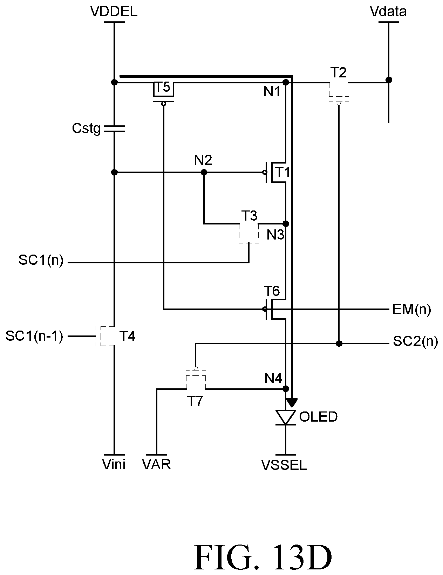

FIG. 13A is a circuit diagram of a pixel of an organic light emitting display device during an on bias stress period according to still another exemplary embodiment (Example 4) of the present disclosure. FIG. 13B is a circuit diagram of a pixel of an organic light emitting display device during an initial period according to still another exemplary embodiment (Example 4) of the present disclosure. FIG. 13C is a circuit diagram of a pixel of an organic light emitting display device during a sampling period according to still another exemplary embodiment (Example 4) of the present disclosure. FIG. 13D is a circuit diagram of a pixel of an organic light emitting display device during an emission period according to still another exemplary embodiment (Example 4) of the present disclosure.

The driving of the pixel of the organic light emitting display device according to still another exemplary embodiment (Example 4) of the present disclosure will be described with reference to FIGS. 12 to 13D, as follows.

The organic light emitting display device according to still another exemplary embodiment (Example 4) of the present disclosure may be driven to be divided into a refresh frame and an anode reset frame. In the refresh frame, the data voltage Vdata is programmed in each pixel P and the organic light emitting diode OLED emits light. The anode reset frame may be a vertical blank frame and the anode electrode of the organic light emitting diode OLED is reset during the anode reset frame.

In the organic light emitting display device according to still another exemplary embodiment (Example 4) of the present disclosure, the anode reset frame may include a plurality of stress periods (on bias stress). The stress period (on bias stress) is a period in which a bias stress is applied to the first node N1 which is the source electrode of the driving transistor T1. Further, during the stress period, the anode electrode of the organic light emitting diode OLED may be reset. Further, as illustrated in FIG. 7, during the anode reset frame, the reset voltage VAR and the initialization voltage Vini are low levels and the data voltage Vdata is a high level.

Also, in the organic light emitting display device according to still another exemplary embodiment (Example 4) of the present disclosure, the refresh frame may be divided into an initial period, a sampling period, and an emission period. The initial period is a period in which the voltage of the second node N2 which is the gate electrode of the driving transistor T1 is initialized. The sampling period is a period in which a threshold voltage Vth of the driving transistor T1 is sampled and the data voltage Vdata is programmed. The emission period is a period in which the organic light emitting diode OLED emits light in accordance with the driving current by the source-gate voltage of the programmed driving transistor T1. As illustrated in FIG. 7, during the refresh frame, the reset voltage VAR and the initialization voltage Vini are low levels.

Specifically, referring to FIGS. 7 and 13A, during the stress period (on bias stress) of the anode reset frame, the second scan signal SC2(n) is a low level which is a turn on level. That is, during the stress period (on bias stress) of the anode reset frame, an odd-numbered second scan signal SC2_Odd(n) is a low level which is a turn on level and an even-numbered second scan signal SC2_Even(n) is a low level which is a turn on level. In other words, in the anode reset frame including a plurality of stress periods (on bias stress), the odd-numbered second scan signal SC2_Odd(n) and the even-numbered second scan signal SC2_Even(n) which are second scan signals SC2(n) may have a waveform including a plurality of pulses. In the anode reset frame including a plurality of stress periods (on bias stress), the data voltage Vdata is always a high level.

Therefore, the seventh transistor T7 is turned on to apply the reset voltage VAR to the fourth node N4. That is, the anode electrode of the organic light emitting diode OLED is reset to the reset voltage VAR.

Therefore, the second transistor T2 is turned on to apply a high level of data voltage Vdata to the first node N1. The high level of data voltage Vdata may be selected in a voltage range which is sufficiently higher than an operating voltage of the organic light emitting diode OLED and may be set to a voltage equal to or less than a high potential driving voltage VDDEL. That is, during the stress period (on bias stress), the on bias stress is applied to the first node N1 which is the source electrode of the driving transistor T1 to drop the gate-source voltage Vgs of the driving transistor T1. Accordingly, during the stress period (on bias stress), the source-drain current Ids of the driving transistor T1 flows to relieve the hysteresis of the driving transistor T1.

Referring to FIGS. 7 and 13B, during an initial period of the refresh frame, the first scan signal SC1(n) is a high level which is a turn on level and the first scan signal SC1(n - 1) of the previous stage is a high level which is a turn on level. Therefore, the third transistor T3 and the fourth transistor T4 are turned on to apply the initialization voltage Vini to the third node N3 and the second node N2. As a result, the gate electrode and the drain electrode of the driving transistor T1 are initialized to the initialization voltage Vini. In the refresh frame, the initialization voltage Vini may be selected in a voltage range which is sufficiently less than an operating voltage of the organic light emitting diode OLED and may be set to a voltage equal to or less than a low potential driving voltage VSSEL.

Referring to FIGS. 7 and 13C, during a sampling period of the refresh frame, the first scan signal SC1(n) is a high level which is a turn on level and the second scan signal SC2(n) is a low level which is a turn on level. During the sampling period of the refresh frame, the first scan signal SC1(n) is a high level which is a turn on level, an odd-numbered second scan signal SC2_Odd(n) is a low level which is a turn on level, and an even-numbered second scan signal SC2_Even(n) is a low level which is a turn on level. In FIG 7, in the refresh frame, the odd-numbered second scan signals SC2_Odd(n) and the even-numbered second scan signals SC2_Even(n) which are second scan signals SC2(n) are illustrated by a waveform including one pulse. However, the present disclosure is not limited thereto and the odd-numbered second scan signals SC2_Odd(n) and the even-numbered second scan signals SC2_Even(n) which are second scan signals SC2(n) may have a waveform including a plurality of pulses.

Therefore, during the sampling period, the second transistor T2 is turned on so that the data voltage Vdata is applied to the first node N1. Further, the third transistor T3 is also turned on so that the driving transistor T1 is diode-connected. Therefore, the gate electrode and the drain electrode of the driving transistor T1 are shorted so that the driving transistor T1 operates as a diode. During the sampling period, a current Ids flows between the source and the drain of the driving transistor T1. The gate electrode and the drain electrode of the driving transistor T1 are diode-connected, so that the voltage of the second node N2 rises by the current flowing from the source electrode to the drain electrode until the gate-source voltage Vgs of the driving transistor T1 becomes Vth. During the sampling period, the voltage of the second node N2 is charged with a voltage Vdata-|Vth| corresponding to the difference between the data voltage Vdata and the threshold voltage Vth of the driving transistor T1.

Further, during the sampling period of the refresh frame, the second scan signal SC2(n) is a low level which is a turn on level, so that the seventh transistor T7 is turned on to apply the reset voltage VAR to the fourth node N4. That is, the anode electrode of the organic light emitting diode OLED is reset to the reset voltage VAR.

Further, in the refresh frame, when the odd-numbered second scan signal SC2_Odd(n) and the even-numbered second scan signal SC2_Even(n) which are second scan signals SC2(n) have a waveform including a plurality of pulses, the second transistor T2 is turned on to apply the data voltage Vdata to the first node N1. Therefore, also in the refresh frame, the bias stress is applied to the first node N1 which is the source electrode of the driving transistor T1 to relieve the hysteresis of the driving transistor T1.

Referring to FIGS. 7 and 13D, during the emission period of the refresh frame, the emission signal EM(n) is a low level which is a turn on level. Therefore, the fifth transistor T5 is turned on to apply the high potential driving voltage VDDEL to the first node N1. The sixth transistor T6 is also turned on to form a current path of the third node N3 and the fourth node N4. As a result, a driving current Ioled passing through the source electrode and the drain electrode of the driving transistor T1 is applied to the organic light emitting diode OLED.

A relational expression of the driving current Ioled flowing through the organic light emitting diode OLED during the emission period is represented by the above-described Equation 1.

As seen from Equation 1, it is understood that in the relational expression of the driving current Ioled, a component of the threshold voltage Vth of the driving transistor T1 is eliminated so that even though in the display device of the present disclosure, the threshold voltage Vth changes, the driving current Ioled does not change. As described above, the display device of the present disclosure may program the data voltage regardless of the variation of the threshold voltage Vth during the sampling period.

As described above, the anode electrode of the organic light emitting diode OLED is reset to the reset voltage VAR in both the stress period of the anode reset frame and the sampling period of the refresh frame.

As a result, also in the organic light emitting display device according to still another exemplary embodiment (Example 4) of the present disclosure, the anode electrode of the organic light emitting diode OLED may be periodically reset during the refresh frame and the reset frame. Accordingly, the consistent rising of the voltage of the anode electrode of the organic light emitting diode OLED due to the leakage current is suppressed even in the driving at a low frequency so that the anode electrode of the organic light emitting diode OLED may maintain a constant voltage level. Accordingly, even though the driving frequency is switched to a low frequency, the luminance variance of the organic light emitting display device is reduced so that the image quality may be increased.

The organic light emitting display device according to still another exemplary embodiment (Example 4) of the present disclosure uses a high level of data voltage Vdata to apply the on bias stress to the driving transistor T1. Accordingly, the organic light emitting display device according to still another exemplary embodiment (Example 4) of the present disclosure does not need to include a separate stage which swings the initialization voltage in the gate driver to apply the on bias stress.

Moreover, as illustrated in FIG. 9, the first gate driver 401 disposed at the left side of the display area A/A includes only the emission signal stage EM, an odd-numbered second scan signal stage SC2_Odd and an even-numbered second scan signal stage SC2_Even, and the second gate driver 402 disposed at the right side of the display area A/A include only a first scan signal stage SC1, an odd-numbered second scan signal stage SC2_Odd and an even-numbered second scan signal stage SC2 Even. However, the first gate driver 401 and the second gate driver 402 may not include a third scan signal stage SC3.

Accordingly, a width of each of the first gate driver 401 and the second gate driver 402 may be reduced from 350 µm to 300 µm as compared with the organic light emitting display device according to still another exemplary embodiment (Example 3) of the present disclosure so that the width of the bezel may be further reduced. Further, there is no need to drive a third scan signal stage, so that the power consumption may also be reduced.

## Claims

1. An organic light emitting display device, comprising:
a display panel (100) in which a plurality of pixels (P) are disposed, wherein each of the plurality of pixels (P) includes:
an organic light emitting diode (OLED) configured to emit light by a driving current (I_{oled});
a first transistor (T1) configured to control the driving current (I_{oled}) and includes a source electrode connected to a first node (N1), a gate electrode connected a second node (N2), and a drain electrode connected to a third node (N3);
a second transistor (T2) connected between a data voltage input terminal and the first node (N1) and configured to apply a data voltage (Vdata) applied to the data voltage input terminal, by the organic light emitting display device, to the first node (N1);
a third transistor (T3) connected between the second and third nodes (N2, N3) so that the driving transistor (T1) forms a diode connection when the third transistor (T3) is turned on;
a fourth transistor (T4) connected between an initialization voltage terminal and the third node (N3) and configured to apply an initialization voltage (Vini) applied to the initialization voltage terminal, by the organic light emitting display device, to the third node (N3);
a fifth transistor (T5) connected between a high potential driving voltage terminal and the first node (N1) and configured to apply a high potential driving voltage (VDDEL) applied to the high potential driving voltage terminal, by the organic light emitting display device, to the first node (N1);
a sixth transistor (T6) connected between the third node (N3) and the organic light emitting diode (OLED) and configured to form a current path between the first transistor (T1) and the organic light emitting diode (OLED);
a seventh transistor (T7) connected between an anode electrode of the organic light emitting diode (OLED) and a reset voltage terminal and configured to apply a low-level reset voltage (VAR) applied to the reset voltage terminal, by the organic light emitting display device, to a fourth node (N4) which is the anode electrode of the organic light emitting diode (OLED); and
a storage capacitor (Cstg) connected between the second node (N2) and the high potential driving voltage terminal,
the organic light emitting display device is configured to be operated in a refresh frame and in a reset frame, wherein in the refresh frame the data voltage (Vdata) is programmed in the pixel (P),
wherein in the reset frame the low-level reset voltage (VAR) is applied to the anode electrode of the organic light emitting diode (OLED) to reset the anode electrode and the data voltage (Vdata) is applied to the source electrode of the first transistor (T1) at a high level, which is higher than an operating voltage of the organic light emitting diode (OLED) and equal to or less than the high potential driving voltage (VDDEL), to apply bias stress to the source electrode of the first transistor,
wherein, during the reset frame, the second transistor (T2) is turned on by a scan signal (Sc2(n)), supplied by the organic light emitting display device, received on a scan signal terminal to apply the data voltage (Vdata) at said high level to the source electrode of the first transistor (T1) and the seventh transistor (T7) is turned on by the scan signal (Sc2(n)), supplied by the organic light emitting display device, to apply the low-level reset voltage (VAR) to the anode electrode of the organic light emitting diode (OLED), and
wherein the initialization voltage (Vini) has a second level during the refresh frame and a first level during the reset frame, wherein the first level is a high level supplied by the organic light emitting display device, such that a potential difference between the gate electrode and the source electrode of the fourth transistor (T4) is reduced, to reduce the leakage current of the fourth transistor (T4), and wherein the second level is a low level supplied by the organic light emitting display device that is lower than the operating voltage of the organic light emitting diode (OLED).

2. The organic light emitting display device according to claim 1, wherein the reset frame includes a plurality of on bias stress periods, wherein during an on bias stress period the first transistor (T1) is connected to the data voltage input terminal to receive the high-level data voltage (Vdata) and the anode electrode of the organic light emitting diode (OLED) is connected to the reset voltage terminal for receiving the low-level reset voltage (VAR) for resetting the anode of the OLED.

3. The organic light emitting display device according to any one of the preceding claims, wherein the third transistor (T3) is an n-type oxide thin film transistor and the first transistor (T1), the second transistor (T2), and the fourth to seventh transistors (T4-T7) are p-type low temperature polycrystalline silicon (LTPS) thin film transistors.

4. The organic light emitting display device according to any one of the preceding claims 1 or 2, wherein the third transistor and the fourth transistor (T4) are an n-type oxide thin film transistor and the first transistor (T1), the second transistor (T2), and the fifth to seventh transistors (T5-T7) are p-type low temperature polycrystalline silicon (LTPS) thin film transistors.

5. The organic light emitting display device according to claim 4, wherein the initialization voltage (Vini) has a second level during the refresh frame and the reset frame.

6. The organic light emitting display device according to claim 1, wherein:
the second transistor (T2) includes a source electrode connected to the data voltage input terminal, a drain electrode connected to the first node (N1), and a gate electrode connected to the scan signal terminal which transmits the scan signal (Sc2(n)), and/or
the third transistor (T3) includes a source electrode connected to the second node (N2), a drain electrode connected to the third node (N3), and a gate electrode connected to another scan signal line which transmits another scan signal (SC1(n)); and/or
the fourth transistor (T4) includes a source electrode connected to the initialization voltage terminal which transmits the initialization voltage (Vini), a drain electrode connected to the third node (N3), and a gate electrode connected to yet another scan signal line which transmits yet another scan signal (Sc3(n)), and/or
the fifth transistor (T5) includes a source electrode connected to the high potential driving voltage terminal, a drain electrode connected to the first node (N1), and a gate electrode connected to an emission signal line which transmits an emission signal (EM(n)); and/or
the sixth transistor (T6) includes a source electrode connected to the third node (N3), a drain electrode connected to the fourth node (N4), and a gate electrode connected to the emission signal line, and/or
the seventh transistor (T7) includes a source electrode connected to the reset voltage terminal which transmits the low-level reset voltage (VAR), a drain electrode connected to the fourth node (N4), and a gate electrode connected to the scan signal terminal which transmits the scan signal (Sc2(n)).

7. The organic light emitting display device according to claim 1, wherein:
the second transistor (T2) includes a source electrode connected to the data voltage input terminal, a drain electrode connected to the first node (N1), and a gate electrode connected to the scan signal line which transmits the scan signal (SC2(n)), and/or
the third transistor (T3) includes a source electrode connected to the second node (N2), a drain electrode connected to the third node (N3), and a gate electrode connected to another scan signal line which transmits another scan signal (Sc1(n)); and/or
the fourth transistor (T4) includes a source electrode connected to the initialization voltage terminal which transmits the initialization voltage (Vini), a drain electrode connected to the third node (N3), and a gate electrode connected to a scan signal line of a previous stage which transmits a scan signal of the previous stage (SC(n-1)), and/or
the fifth transistor (T5) includes a source electrode connected to the high potential driving voltage terminal, a drain electrode connected to the first node (N1), and a gate electrode connected to an emission signal line which transmits an emission signal (EM(n); and/or
the sixth transistor (T6) includes a source electrode connected to the third node (N3), a drain electrode connected to the fourth node (N4), and a gate electrode connected to the emission signal line, and/or
the seventh transistor (T7) includes a source electrode connected to the reset voltage terminal, a drain electrode connected to the fourth node (N4), and a gate electrode connected to the scan signal terminal which transmits the scan signal (Sc2(n)).

8. The organic light emitting display device according to any one of the preceding claims, wherein the refresh frame is divided into an initial period, a sampling period, and an emission period,
during the initial period, the third node (N3) is initialized to the initialization voltage (Vini),
during the sampling period, the second node (N2) is charged with a voltage corresponding to a difference between the data voltage (Vdata) and a threshold voltage (Vth) of the first transistor (T1), and
during the emission period, the driving current (I_{oled}) flows to the organic light emitting diode (OLED) to emit light.

## Patentansprüche

1. Organische lichtemittierende Anzeigevorrichtung, die umfasst:
eine Anzeigetafel (100), in der mehrere Pixel (P) angeordnet sind, wobei jedes der mehreren Pixel (P) enthält:
eine organische lichtemittierende Diode (OLED), die konfiguriert ist, Licht durch einen Ansteuerungsstrom (I_{oled}) auszusenden;
einen ersten Transistor (T1), der konfiguriert ist, den Ansteuerungsstrom (I_{oled}) zu steuern, und der eine Source-Elektrode, die mit einem ersten Knoten (N1) verbunden ist, eine Gate-Elektrode, die mit einem zweiten Knoten (N2) verbunden ist, und eine Drain-Elektrode, die mit einem dritten Knoten (N3) verbunden ist, enthält;
einen zweiten Transistor (T2), der zwischen einem Datenspannungseingangsanschluss und dem ersten Knoten (N1) angeschlossen ist und konfiguriert ist, eine Datenspannung (Vdata), die an den Datenspannungseingangsanschluss angelegt wird, durch die organische lichtemittierende Anzeigevorrichtung an den ersten Knoten (N1) anzulegen;
einen dritten Transistor (T3), der zwischen dem zweiten und dem dritten Knoten (N2, N3) angeschlossen ist, so dass der Ansteuerungstransistor (T1) eine Diodenverbindung bildet, wenn der dritte Transistor (T3) eingeschaltet ist;
einen vierten Transistor (T4), der zwischen einem Initialisierungsspannungsanschluss und dem dritten Knoten (N3) angeschlossen ist und konfiguriert ist, eine Initialisierungsspannung (Vini), die an den Initialisierungsspannungsanschluss angelegt wird, durch die organische lichtemittierende Anzeigevorrichtung an den dritten Knoten (N3) anzulegen;
einen fünften Transistor (T5), der zwischen einem Hochpotenzialansteuerungsspannungsanschluss und dem ersten Knoten (N1) angeschlossen ist und konfiguriert ist, eine Hochpotenzialansteuerungsspannung (VDDEL), die an den Hochpotenzialansteuerungsspannungsanschluss angelegt wird, durch die organische lichtemittierende Anzeigevorrichtung an den ersten Knoten (N1) anzulegen;
einen sechsten Transistor (T6), der zwischen dem dritten Knoten (N3) und der organischen lichtemittierenden Diode (OLED) angeschlossen ist und konfiguriert ist, einen Strompfad zwischen dem ersten Transistor (T1) und der organischen lichtemittierenden Diode (OLED) zu bilden;
einen siebten Transistor (T7), der zwischen einer Anodenelektrode der organischen lichtemittierenden Diode (OLED) und einem Rückstellspannungsanschluss angeschlossen ist und konfiguriert ist, eine Tiefpegelrückstellspannung (VAR), die an den Rückstellspannungsanschluss angelegt wird, durch die organische lichtemittierende Anzeigevorrichtung an einen vierten Knoten (N4), der die Anodenelektrode der organischen lichtemittierenden Diode (OLED) ist, anzulegen; und
einen Speicherkondensator (Cstg), der zwischen dem zweiten Knoten (N2) und dem Hochpotenzialansteuerungsspannungsanschluss angeschlossen ist,
wobei die organische lichtemittierende Anzeigevorrichtung konfiguriert ist, in einem Auffrischungsrahmen und einem Rückstellrahmen betrieben zu werden, wobei in dem Auffrischungsrahmen die Datenspannung (Vdata) in dem Pixel (P) programmiert ist,
wobei in dem Rückstellrahmen die Tiefpegelrückstellspannung (VAR) an die Anodenelektrode der organischen lichtemittierenden Diode (OLED) angelegt wird, um die Anodenelektrode zurückzusetzen, und die Datenspannung (Vdata) an die Source-Elektrode des ersten Transistors (T1) mit einem hohen Pegel, der höher als eine Betriebsspannung der organischen lichtemittierenden Diode (OLED) und gleich der Hochpotenzialansteuerungsspannung (VDDEL) oder kleiner als diese ist, angelegt wird, um eine Vorspannungsbelastung an die Source-Elektrode des ersten Transistors anzulegen,
wobei während des Rückstellrahmens der zweite Transistor (T2) durch ein Abtastsignal (Sc2(n)), das durch die organische lichtemittierende Anzeigevorrichtung geliefert wird, und an einem Abtastsignalanschluss empfangen wird, eingeschaltet wird, um die Datenspannung (Vdata) mit dem hohen Pegel an die Source-Elektrode des ersten Transistors (T1) anzulegen, und der siebte Transistor (T7) durch das Abtastsignal (Sc2(n)), das durch die organische lichtemittierende Anzeigevorrichtung geliefert wird, eingeschaltet wird, um die Tiefpegelrückstellspannung (VAR) an die Anodenelektrode der organischen lichtemittierenden Diode (OLED) anzulegen, und
wobei die Initialisierungsspannung (Vini) einen zweiten Pegel während des Auffrischungsrahmens und einen ersten Pegel während des Rückstellrahmens besitzt, wobei der erste Pegel ein hoher Pegel ist, der durch die organische lichtemittierende Anzeigevorrichtung geliefert wird, so dass ein Potenzialunterschied zwischen der Gate-Elektrode und der Source-Elektrode des vierten Transistors (T4) verringert wird, um den Leckstrom des vierten Transistors (T4) zu verringern, und wobei der zweite Pegel ein tiefer Pegel ist, der durch die organische lichtemittierende Anzeigevorrichtung geliefert wird und der tiefer als die Betriebsspannung der organischen lichtemittierenden Diode (OLED) ist.

2. Organische lichtemittierende Anzeigevorrichtung nach Anspruch 1, wobei der Rückstellrahmen mehrere Vorspannungsbelastungsperioden enthält, wobei während einer Vorspannungsbelastungsperiode der erste Transistor (T1) mit dem Datenspannungseingangsanschluss verbunden ist, um die Hochpegeldatenspannung (Vdata) zu empfangen, und die Anodenelektrode der organischen lichtemittierenden Diode (OLED) mit dem Rückstellspannungsanschluss zum Empfangen der Tiefpegelrückstellspannung (VAR) zum Rückstellen der Anode der OLED verbunden ist.

3. Organische lichtemittierende Anzeigevorrichtung nach einem der vorhergehenden Ansprüche, wobei der dritte Transistor (T3) ein N-Typ-Oxid-Dünnschichttransistor ist und der erste Transistor (T1), der zweite Transistor (T2) und der vierte bis siebte Transistor (T4-T7) P-Typ-Niedertemperatur-Polykristallinsilizium-Dünnschichttransistoren (LTPS-Dünnschichttransistoren) sind.

4. Organische lichtemittierende Anzeigevorrichtung nach einem der vorhergehenden Ansprüche 1 oder 2, wobei der dritte Transistor und der vierte Transistor (T4) N-Typ-Oxid-Dünnschichttransistoren sind und der erste Transistor (T1), der zweite Transistor (T2) und der fünfte bis siebte Transistor (T5-T7) P-Typ-Niedertemperatur-Polykristallinsilizium-Dünnschichttransistoren (LTPS-Dünnschichttransistoren) sind.

5. Organische lichtemittierende Anzeigevorrichtung nach Anspruch 4, wobei die Initialisierungsspannung (Vini) einen zweiten Pegel während des Auffrischungsrahmens und des Rückstellrahmens besitzt.

6. Organische lichtemittierende Anzeigevorrichtung nach Anspruch 1, wobei:
der zweite Transistor (T2) eine Source-Elektrode, die mit dem Datenspannungseingangsanschluss verbunden ist, eine Drain-Elektrode, die mit dem ersten Knoten (N1) verbunden ist, und eine Gate-Elektrode, die mit dem Abtastsignalanschluss verbunden ist, der das Abtastsignal (Sc2(n)) überträgt, enthält und/oder
der dritte Transistor (T3) eine Source-Elektrode, die mit dem zweiten Knoten (N2) verbunden ist, eine Drain-Elektrode, die mit dem dritten Knoten (N3) verbunden ist, und eine Gate-Elektrode, die mit einer weiteren Abtastsignalleitung, die ein weiteres Abtastsignal (SC1(n)) überträgt, verbunden ist, enthält; und/oder
der vierte Transistor (T4) eine Source-Elektrode, die mit dem Initialisierungsspannungsanschluss verbunden ist, der die Initialisierungsspannung (Vini) überträgt, eine Drain-Elektrode, die mit dem dritten Knoten (N3) verbunden ist, und eine Gate-Elektrode, die mit noch einer weiteren Abtastsignalleitung, die noch ein weiteres Abtastsignal (Sc3(n)) überträgt, verbunden ist, enthält und/oder
der fünfte Transistor (T5) eine Source-Elektrode, die mit dem Hochpotenzialansteuerungsspannungsanschluss verbunden ist, eine Drain-Elektrode, die mit dem ersten Knoten (N1) verbunden ist, und eine Gate-Elektrode, die mit einer Emissionssignalleitung, die ein Emissionssignal (EM(n)) überträgt, verbunden ist, enthält; und/oder
der sechste Transistor (T6) eine Source-Elektrode, die mit dem dritten Knoten (N3) verbunden ist, eine Drain-Elektrode, die mit dem vierten Knoten (N4) verbunden ist, und eine Gate-Elektrode, die mit der Emissionssignalleitung verbunden ist, enthält, und/oder
der siebte Transistor (T7) eine Source-Elektrode, die mit dem Rückstellspannungsanschluss verbunden ist, der die Tiefpegelrückstellspannung (VAR) überträgt, eine Drain-Elektrode, die mit dem vierten Knoten (N4) verbunden ist, und eine Gate-Elektrode, die mit dem Abtastsignalanschluss verbunden ist, der das Abtastsignal (Sc2(n)) überträgt, enthält.

7. Organische lichtemittierende Anzeigevorrichtung nach Anspruch 1, wobei:
der zweite Transistor (T2) eine Source-Elektrode, die mit dem Datenspannungseingangsanschluss verbunden ist, eine Drain-Elektrode, die mit dem ersten Knoten (N1) verbunden ist, und eine Gate-Elektrode, die mit der Abtastsignalleitung, die das Abtastsignal (Sc2(n)) überträgt, verbunden ist, enthält und/oder
der dritte Transistor (T3) eine Source-Elektrode, die mit dem zweiten Knoten (N2) verbunden ist, eine Drain-Elektrode, die mit dem dritten Knoten (N3) verbunden ist, und eine Gate-Elektrode, die mit einer weiteren Abtastsignalleitung, die ein weiteres Abtastsignal (SC1(n)) überträgt, verbunden ist, enthält; und/oder
der vierte Transistor (T4) eine Source-Elektrode, die mit dem Initialisierungsspannungsanschluss verbunden ist, der die Initialisierungsspannung (Vini) überträgt, eine Drain-Elektrode, die mit dem dritten Knoten (N3) verbunden ist, und eine Gate-Elektrode, die mit einer Abtastsignalleitung einer vorherigen Stufe, die ein Abtastsignal einer vorherigen Stufe (Sc3(n-1)) überträgt, verbunden ist, enthält und/oder
der fünfte Transistor (T5) eine Source-Elektrode, die mit dem Hochpotenzialansteuerungsspannungsanschluss verbunden ist, eine Drain-Elektrode, die mit dem ersten Knoten (N1) verbunden ist, und eine Gate-Elektrode, die mit einer Emissionssignalleitung, die ein Emissionssignal (EM(n)) überträgt, verbunden ist, enthält; und/oder
der sechste Transistor (T6) eine Source-Elektrode, die mit dem dritten Knoten (N3) verbunden ist, eine Drain-Elektrode, die mit dem vierten Knoten (N4) verbunden ist, und eine Gate-Elektrode, die mit der Emissionssignalleitung verbunden ist, enthält, und/oder
der siebte Transistor (T7) eine Source-Elektrode, die mit dem Rückstellspannungsanschluss verbunden ist, eine Drain-Elektrode, die mit dem vierten Knoten (N4) verbunden ist, und eine Gate-Elektrode, die mit dem Abtastsignalanschluss, der das Abtastsignal (Sc2(n)) überträgt, verbunden ist, enthält.

8. Organische lichtemittierende Anzeigevorrichtung nach einem der vorhergehenden Ansprüche, wobei der Auffrischungsrahmen in eine Anfangsperiode, eine Abtastperiode und eine Emissionsperiode unterteilt ist,
während der Anfangsperiode der dritte Knoten (N3) auf die Initialisierungsspannung (Vini) initialisiert wird,
während der Abtastperiode der zweite Knoten (N2) mit einer Spannung geladen wird, die einem Unterschied zwischen der Datenspannung (Vdata) und einer Schwellenspannung (Vth) des ersten Transistors (T1) entspricht, und
während der Emissionsperiode der Ansteuerungsstrom (I_{oled}) zu der organischen lichtemittierenden Diode (OLED) fließt, um Licht auszusenden.

## Revendications

1. Dispositif d'affichage électroluminescent organique, comportant :
un panneau d'affichage (100) dans lequel une pluralité de pixels (P) sont disposés, dans lequel chaque pixel de la pluralité de pixels (P) inclut :
une diode électroluminescente organique (OLED) configurée pour émettre de la lumière par un courant d'attaque (I_{oled}) ;
un premier transistor (T1) configuré pour commander le courant d'attaque (I_{oled}) et inclut une électrode de source connectée à un premier nœud (N1), une électrode de grille connectée à un deuxième nœud (N2), et une électrode de drain connectée à un troisième nœud (N3) ;
un deuxième transistor (T2) connecté entre une borne d'entrée de tension de données et le premier nœud (N1) et configuré pour appliquer une tension de données (Vdata) appliquée à la borne d'entrée de tension de données, par le dispositif d'affichage électroluminescent organique, au premier nœud (N1) ;
un troisième transistor (T3) connecté entre les deuxième et troisième nœuds (N2, N3) de sorte que le transistor d'attaque (T1) forme une connexion de diode lorsque le troisième transistor (T3) est mis à l'état passant ;
un quatrième transistor (T4) connecté entre une borne de tension d'initialisation et le troisième nœud (N3) et configuré pour appliquer une tension d'initialisation (Vini) appliquée à la borne de tension d'initialisation, par le dispositif d'affichage électroluminescent organique, au troisième nœud (N3);
un cinquième transistor (T5) connecté entre une borne de tension d'attaque à potentiel élevé et le premier nœud (N1) et configuré pour appliquer une tension d'attaque à potentiel élevé (VDDEL) appliquée à la borne de tension d'attaque à potentiel élevé, par le dispositif d'affichage électroluminescent organique, au premier nœud (N1) ;
un sixième transistor (T6) connecté entre le troisième nœud (N3) et la diode électroluminescente organique (OLED) et configuré pour former un trajet de courant entre le premier transistor (T1) et la diode électroluminescente organique (OLED) ;
un septième transistor (T7) connecté entre une électrode d'anode de la diode électroluminescente organique (OLED) et une borne de tension de réinitialisation et configuré pour appliquer une tension de réinitialisation de niveau bas (VAR) appliquée à la borne de tension de réinitialisation, par le dispositif d'affichage électroluminescent organique, à un quatrième nœud (N4) qui est l'électrode d'anode de la diode électroluminescente organique (OLED) ; et
un condensateur de stockage (Cstg) connecté entre le deuxième nœud (N2) et la borne de tension d'attaque à potentiel élevé,
le dispositif d'affichage électroluminescent organique est configuré pour fonctionner dans une trame de rafraîchissement et dans une trame de réinitialisation, dans lequel, dans la trame de rafraîchissement, la tension de données (Vdata) est programmée dans le pixel (P),
dans lequel, dans la trame de réinitialisation, la tension de réinitialisation de niveau bas (VAR) est appliquée à l'électrode d'anode de la diode électroluminescente organique (OLED) pour réinitialiser l'électrode d'anode et la tension de données (Vdata) est appliquée à l'électrode de source du premier transistor (T1) à un niveau haut, qui est supérieur à une tension de fonctionnement de la diode électroluminescente organique (OLED) et égal ou inférieur à la tension d'attaque à potentiel élevé (VDDEL), pour appliquer une contrainte de polarisation à l'électrode de source du premier transistor,
dans lequel, pendant la trame de réinitialisation, le deuxième transistor (T2) est mis à l'état passant par un signal de balayage (SC2(n)), fourni par le dispositif d'affichage électroluminescent organique, reçu sur une borne de signal de balayage pour appliquer la tension de données (Vdata) audit niveau haut à l'électrode de source du premier transistor (T1), et le septième transistor (T7) est mis à l'état passant par le signal de balayage (SC2(n), fourni par le dispositif d'affichage électroluminescent organique (OLED), pour appliquer la tension de réinitialisation de niveau bas (VAR) à l'électrode d'anode de la diode électroluminescente (OLED), et
dans lequel la tension d'initialisation (Vini) a un second niveau pendant la trame de rafraîchissement et un premier niveau pendant la trame de réinitialisation, dans lequel le premier niveau est un niveau haut fourni par le dispositif d'affichage électroluminescent organique, de telle sorte qu'une différence de potentiel entre l'électrode de grille et l'électrode de source du quatrième transistor (T4) est réduite, afin de réduire le courant de fuite du quatrième transistor (T4), et dans lequel le second niveau est un niveau bas fourni par le dispositif d'affichage électroluminescent organique qui est inférieur à la tension de fonctionnement de la diode électroluminescente organique (OLED).

2. Dispositif d'affichage électroluminescent organique selon la revendication 1, dans lequel la trame de réinitialisation inclut une pluralité de périodes de contrainte de polarisation à l'état passant, dans lequel pendant une période de contrainte de polarisation à l'état passant, le premier transistor (T1) est connecté à la borne d'entrée de tension de données pour recevoir la tension de données de niveau haut (Vdata) et l'électrode d'anode de la diode électroluminescente organique (OLED) est connectée à la borne de tension de réinitialisation pour recevoir la tension de réinitialisation de niveau bas (VAR) pour réinitialiser l'anode de l'OLED.

3. Dispositif d'affichage électroluminescent organique selon l'une quelconque des revendications précédentes, dans lequel le troisième transistor (T3) est un transistor à couches minces d'oxyde de type n et le premier transistor (T1), le deuxième transistor (T2) et les quatrième à septième transistors (T4 à T7) sont des transistors à couches minces de silicium polycristallin à basse température (LTPS) de type p.

4. Dispositif d'affichage électroluminescent organique selon l'une quelconque des revendications 1 ou 2 précédentes, dans lequel le troisième transistor et le quatrième transistor (T4) sont un transistor à couches minces d'oxyde de type n et le premier transistor (T1), le deuxième transistor (T2) et les cinquième à septième transistors (T5 à T7) sont des transistors à couches minces de silicium polycristallin à basse température (LTPS) de type p.

5. Dispositif d'affichage électroluminescent organique selon la revendication 4, dans lequel la tension d'initialisation (Vini) a un second niveau pendant la trame de rafraîchissement et la trame de réinitialisation.

6. Dispositif d'affichage électroluminescent organique selon la revendication 1, dans lequel :
le deuxième transistor (T2) inclut une électrode de source connectée à la borne d'entrée de tension de données, une électrode de drain connectée au premier nœud (N1), et une électrode de grille connectée à la borne de signal de balayage qui transmet le signal de balayage (SC2(n)), et/ou
le troisième transistor (T3) inclut une électrode de source connectée au deuxième nœud (N2), une électrode de drain connectée au troisième nœud (N3), et une électrode de grille connectée à une autre ligne de signal de balayage qui transmet un autre signal de balayage (SC1(n)) ; et/ou
le quatrième transistor (T4) inclut une électrode de source connectée à la borne de tension d'initialisation qui transmet la tension d'initialisation (Vini), une électrode de drain connectée au troisième nœud (N3), et une électrode de grille connectée à encore une autre ligne de signal de balayage qui transmet encore un autre signal de balayage (SC3(n)), et/ou
le cinquième transistor (T5) inclut une électrode de source connectée à la borne de tension d'attaque à potentiel élevé, une électrode de drain connectée au premier nœud (N1), et une électrode de grille connectée à une ligne de signal d'émission qui transmet un signal d'émission (EM(n)) ; et/ou
le sixième transistor (T6) inclut une électrode de source connectée au troisième nœud (N3), une électrode de drain connectée au quatrième nœud (N4), et une électrode de grille connectée à la ligne de signal d'émission, et/ou
le septième transistor (T7) inclut une électrode de source connectée à la borne de tension de réinitialisation qui transmet la tension de réinitialisation de niveau bas (VAR), une électrode de drain connectée au quatrième nœud (N4), et une électrode de grille connectée à la borne de signal de balayage qui transmet le signal de balayage (SC2(n)).

7. Dispositif d'affichage électroluminescent organique selon la revendication 1, dans lequel :
le deuxième transistor (T2) inclut une électrode de source connectée à la borne d'entrée de tension de données, une électrode de drain connectée au premier nœud (N1), et une électrode de grille connectée à la ligne de signal de balayage qui transmet le signal de balayage (SC2(n)), et/ou
le troisième transistor (T3) inclut une électrode de source connectée au deuxième nœud (N2), une électrode de drain connectée au troisième nœud (N3), et une électrode de grille connectée à une autre ligne de signal de balayage qui transmet un autre signal de balayage (Sc1(n)) ; et/ou
le quatrième transistor (T4) inclut une électrode de source connectée à la borne de tension d'initialisation qui transmet la tension d'initialisation (Vini), une électrode de drain connectée au troisième nœud (N3), et une électrode de grille connectée à une ligne de signal de balayage d'un étage précédent qui transmet un signal de balayage de l'étage précédent (SC(n-1)), et/ou
le cinquième transistor (T5) inclut une électrode de source connectée à la borne de tension d'attaque à potentiel élevé, une électrode de drain connectée au premier nœud (N1), et une électrode de grille connectée à une ligne de signal d'émission qui transmet un signal d'émission (EM(n)) ; et/ou
le sixième transistor (T6) inclut une électrode de source connectée au troisième nœud (N3), une électrode de drain connectée au quatrième nœud (N4), et une électrode de grille connectée à la ligne de signal d'émission, et/ou
le septième transistor (T7) inclut une électrode de source connectée à la borne de tension de réinitialisation, une électrode de drain connectée au quatrième nœud (N4), et une électrode de grille connectée à la borne de signal de balayage qui transmet le signal de balayage (SC2(n)).

8. Dispositif d'affichage électroluminescent organique selon l'une quelconque des revendications précédentes, dans lequel la trame de rafraîchissement est divisée en une période initiale, une période d'échantillonnage et une période d'émission,
pendant la période initiale, le troisième nœud (N3) est initialisé à la tension d'initialisation (Vini),
pendant la période d'échantillonnage, le deuxième nœud (N2) est chargé avec une tension correspondant à une différence entre la tension de données (Vdata) et une tension de seuil (Vth) du premier transistor (T1), et
pendant la période d'émission, le courant d'attaque (I_{oled}) circule vers la diode électroluminescente organique (OLED) pour émettre de la lumière.
